(19) Europäisches Patentamt / European Patent Office / Office européen des brevets

(11) **EP 2 975 651 B1**

(12) **FASCICULE DE BREVET EUROPEEN**

(45) Date de publication et mention de la délivrance du brevet:
**14.11.2018 Bulletin 2018/46**

(51) Int Cl.:
***H01L 31/054*** *(2014.01)*

(21) Numéro de dépôt: **15176349.7**

(22) Date de dépôt: **10.07.2015**

(54) **MODULE PHOTOVOLTAÏQUE COMPRENANT UNE OPTIQUE DE CONCENTRATION AVEC DES MOTIFS SUB-LONGUEURS D'ONDE ET GENERATEUR SOLAIRE POUR SATELLITE COMPRENANT LEDIT MODULE**

FOTOVOLTAIKMODUL MIT KONZENTRATIONSOPTIK UMFASSEND SUBWELLENLÄNGENMERKMALE UND SOLARGENERATOR FÜR SATELLIT, DER EIN SOLCHES MODUL UMFASST

PHOTOVOLTAIC MODULE COMPRISING CONCENTRATION OPTICS WITH SUB-WAVELENGTH FEATURES AND SOLAR GENERATOR FOR SATELLITE COMPRISING SAID MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.07.2014 FR 1401587**

(43) Date de publication de la demande:
**20.01.2016 Bulletin 2016/03**

(73) Titulaire: **THALES**
**92400 Courbevoie (FR)**

(72) Inventeurs:
• **LEE-BOUHOURS, Mane-Si Laure**
**91470 LES MOLIERES (FR)**
• **LOISEAUX, Brigitte**
**91440 BURES SUR YVETTE (FR)**
• **DIAZ, Frédéric**
**42570 Saint Heand (FR)**
• **LEHOUCQ, Gaëlle**
**91300 MASSY (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
| | |
|---|---|
| **WO-A2-2011/041637** | **WO-A2-2013/005231** |
| **FR-A1- 2 975 506** | **US-A- 4 418 238** |
| **US-A1- 2013 153 000** | **US-A1- 2014 130 855** |

**EP 2 975 651 B1**

**Description**

Le domaine de l'invention est celui des dispositifs photovoltaïques comprenant des optiques de concentration permettant d'en augmenter les performances.

De manière générale, dans les applications terrestres utilisant des panneaux solaires, et ce en grande quantité, il est essentiel de chercher à réduire les coûts des modules photovoltaïques utilisés, tout en en augmentant l'efficacité.

Pour réduire les coûts, différentes stratégies sont employées. Elles peuvent notamment porter sur :

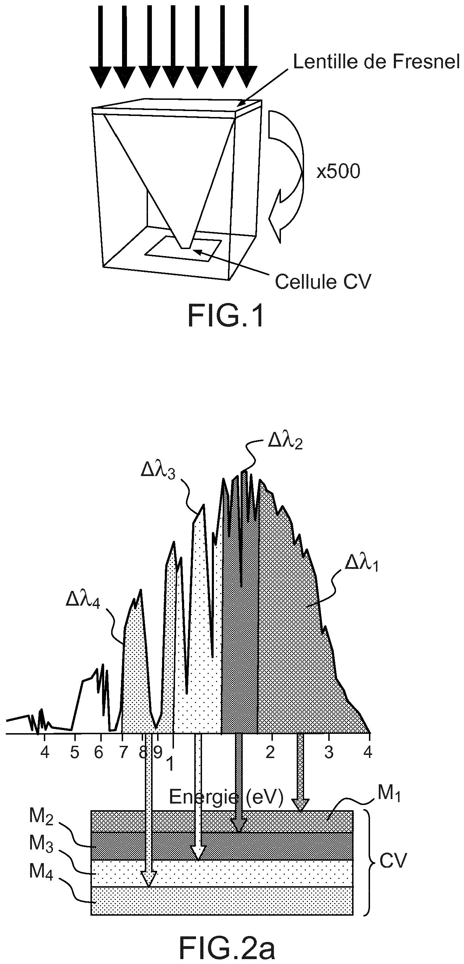

- la cellule de matériau photosensible employée. On peut chercher à en réduire l'épaisseur, en utilisant des films minces de matériau, sur substrats bas coût ou en jouant sur la nature même du matériau ;
- l'architecture de la structure en utilisant des systèmes à concentrateur de lumière qui focalisent la lumière incidente sur une cellule de surface plus petite pour réduire la surface de matériau photovoltaïque. La figure 1 représente un module à concentrateur photovoltaïque, utilisant une lentille de Fresnel à base de microprismes. Par construction géométrique, on est capable de réduire fortement la taille de la cellule. Actuellement les facteurs de concentration sont de l'ordre de 500, voire plus, pour les applications terrestres. Dans ce cas un système de suivi du soleil, dénommé couramment « tracking » deux axes est nécessaire pour suivre au mieux l'orientation du soleil.

Parmi ces différentes stratégies, les efforts se portent en priorité sur l'augmentation de l'efficacité ou rendement de la cellule.

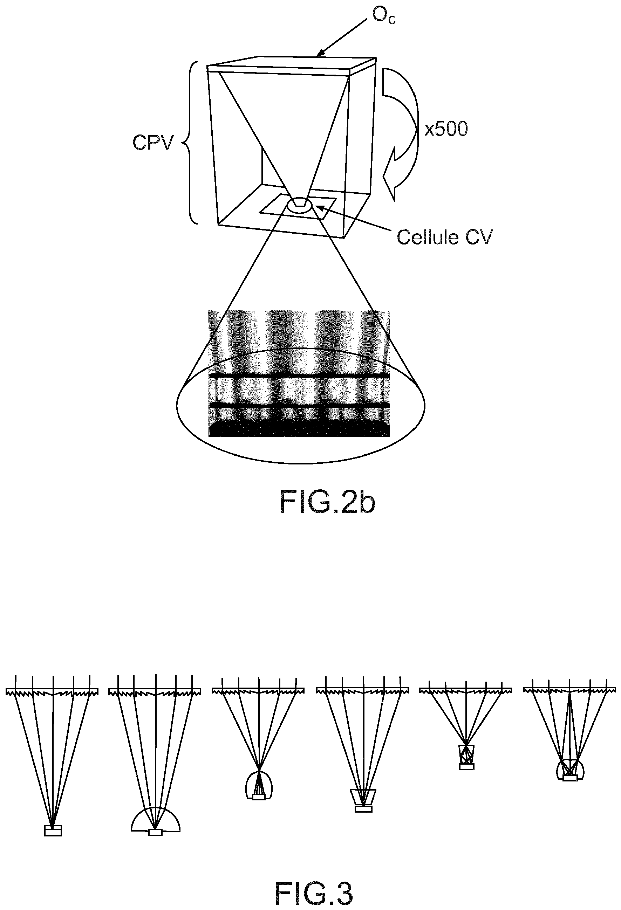

La technologie présentant les meilleurs rendements et ayant la plus grande pente de progression est la technologie à base de structure dite multijonction, combinée à un concentrateur. Une structure multijonction comprend l'empilement de différentes jonctions constituées de différents matériaux sensibles dans des gammes de longueurs d'onde différentes, ayant pour avantage de pouvoir capter de manière efficace toute la gamme spectrale constituant le spectre solaire. Une structure multijonction offre un rendement meilleur qu'une structure simple jonction mais représente un coût plus important lié à sa plus grande complexité. C'est pourquoi, il peut être intéressant de combiner une structure multijonction à un concentrateur de lumière, pour réduire fortement la surface de la cellule et donc le coût du module complet. A titre illustratif, les figures 2a et 2b représentent respectivement :

- une cellule photovoltaïque CV comprenant dans l'exemple illustré l'empilement de matériaux M1, M2, M3 et M4 sensibles dans des gammes de longueurs d'onde $\Delta\lambda1$, $\Delta\lambda2$, $\Delta\lambda3$ et $\Delta\lambda4$ ;
- un module photovoltaïque CPV utilisant une optique de concentration Oc et ladite cellule CV.

Le rendement d'un module CPV à multijonction est d'environ 41% pour une triple jonction à base de GaInP/GaInAs/Ge, pouvant atteindre des rendements de 44,7% pour une quadruple jonction, (avec une simple jonction GaAs, le rendement maximal est de l'ordre de 32%).

La figure 3 extraite de l'article de P. Benítez, J.C. Miñano, P. Zamora, R. Mohedano, A. Cvetkovic, M. Buljan, J. Chaves, M. Hernández, « High performance Fresnel-based photovoltaic Concentrator », Optics express, vol 18,S1, page A25-A40 (2010) illustre différents types de concentrateurs fonctionnant en transmission et utilisés pour des modules photovoltaïques terrestres et plus précisément de gauche à droite :

- un concentrateur à base d'une lentille de Fresnel à microprismes (sans élément optique secondaire) ;
- un concentrateur avec pour élément optique secondaire, un dôme sphérique ;
- un concentrateur avec pour élément optique secondaire, un composant SILO (SIngLe Optical surface) proposé par le laboratoire Sandia Labs ;
- un concentrateur avec pour élément optique secondaire, une pyramide réfléchissante creuse tronquée (XTP), utilisé par la compagnie Amonix ;
- un concentrateur avec pour élément optique secondaire, une pyramide diélectrique tronquée (RTP), utilisée par la société Solfocus ;
- un concentrateur avec pour élément optique secondaire, un concentreur de Fresnel Köhler (FK) à quatre quadrants, proposé par Benitez et al.

De manière générale, l'optique primaire (correspondant à la partie supérieure des configurations représentées en figure 3) est appelée lentille de Fresnel, appelée de type micro-prisme, exclusivement basée sur le principe de la réfraction.

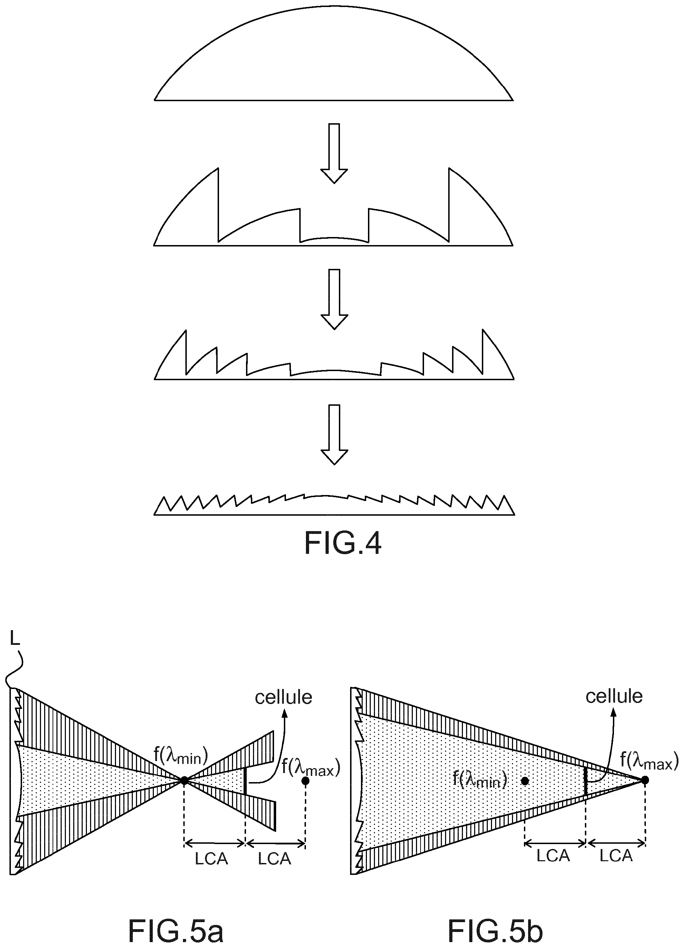

En effet, la même fonction de focalisation peut être maintenue en enlevant de la matière tant que la surface courbe est maintenue. Le principe de construction d'une telle lentille est illustré en Figure 4. La lentille est composée de plusieurs micro-prismes. L'utilisation des micro-prismes permet une approche plus compacte que celle obtenue avec une lentille réfractive standard pour la focalisation de la lumière, comme décrit dans l'article de : A. Davis, F. Kuhnlenz « Optical Design using Fresnel Lenses », Optik & Photonik, December 2007 N°4. Elles ont pour avantage d'être plates (typiquement entre $200\mu$m et 3mm d'épaisseur) par rapport à des lentilles réfractives classiques, mais, comme ces dernières, elles sont chromatiques, la distance focale dépendant de la dispersion du matériau.

Les figures 5a et 5b illustrent l'effet de cette dispersion de l'indice de réfraction du matériau sur l'efficacité de la lentille (le taux de lumière arrivant sur la cellule) pour un rayonnement émettant à une longueur d'onde minimale $\lambda_{min}$ et une longueur d'onde maximale $\lambda_{Max}$, en supposant que l'on place la cellule de manière équidistante des deux points de focalisation $f(\lambda_{min})$ et $f(\lambda_{Max})$. On remarque que la quantité de lumière collectée à $\lambda_{min}$ comme représenté en figure 5a (zone grise foncée) est inférieure à la quantité de lumière collectée à $\lambda_{Max}$ comme représentée en figure 5b (zone grisée claire), les zones hachurées correspondant à la lumière perdue.

Le point essentiel est donc de trouver le meilleur compromis pour le placement de la cellule selon l'axe optique (longitudinalement), pour optimiser le rendement optique. Du fait du chromatisme, la lumière à la longueur d'onde $\lambda_{min}$ focalise à une distance $f(\lambda_{min})$ différente de la lumière à la longueur d'onde $\lambda_{Max}$ qui focalise à $f(\lambda_{Max})$. La lumière du soleil étant large bande, il s'agit de trouver le meilleur compromis pour le placement de la cellule. Dans un premier temps le premier réflexe en imagerie consiste à placer la cellule équidistante entre les deux points de focalisation $f(\lambda_{min})$ et $f(\lambda_{Max})$. Cependant, cette position n'est pas optimale puisque du point de vue de la collection de lumière, la quantité de lumière collectée à $\lambda_{min}$ (zone grise foncée de la figure 5a) est inférieure à la quantité de lumière collectée à $\lambda_{Max}$ (zone grisée de la figure 5b), les zones hachurées correspondent à la lumière perdue.

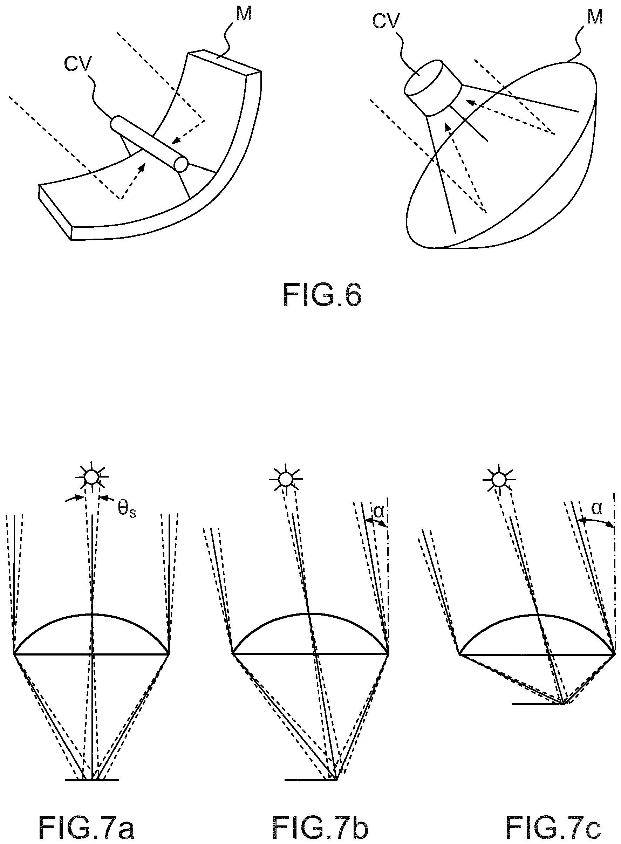

En parallèle de ces systèmes en transmission, il existe également des systèmes en réflexion. La figure 6 illustre quelques exemples de systèmes en réflexion basés sur des systèmes à miroirs M renvoyant le rayonnement lumineux focalisé en direction de la cellule CV. Leur avantage est leur insensibilité à la longueur d'onde, cependant, ils présentent une zone d'obscuration et sont plus volumineux.

Il convient par ailleurs de prendre en compte, en plus de l'efficacité optique, deux paramètres importants intervenant dans le dimensionnement d'un module CPV : l'ouverture de la source et les effets thermiques.

Ainsi, il convient de prendre en compte la notion d'angle d'acceptance, paramètre majeur et qui est fonction du facteur de concentration. Pour les applications terrestres où les facteurs de concentration peuvent être très importants, les angles d'acceptance sont très faibles, de l'ordre de 0.5°-1°. Il est donc nécessaire d'intégrer un système de tracking, généralement complexe et onéreux.

Les figures 7a, 7b et 7c illustrent les contraintes géométriques liées au diamètre angulaire du soleil $\theta$s (typiquement de 0.5°) et l'angle d'acceptance $\alpha$ du dispositif, selon trois configurations différentes et ce en supposant dans les trois cas, une taille de cellule fixée et un diamètre de lentille fixé. Plus précisément :

- la figure 7a représente le tracé de rayons lorsque le soleil est à la verticale, incidence dite « normale ». Le rayon principal correspond aux lignes continues. Les rayons prenant en compte la dimension du soleil sont en traits pointillés ;
- la figure 7b représente le tracé de rayons lorsque le soleil tourne, incidence dite « oblique ». L'angle d'acceptance $\alpha$ est défini par l'angle maximum d'inclinaison du rayon principal pour qu'il ne quitte pas la zone sensible ;
- la figure 7c représente le tracé de rayon sur une lentille plus ouverte (correspondant à un rapport focale-sur-diamètre plus petit), l'angle d'acceptance augmente.

Pour augmenter l'angle d'acceptance, on peut, à taille de cellule constante, augmenter l'ouverture numérique de la lentille (pour cela il convient de diminuer la focale de la lentille, ce qui revient effectivement à augmenter l'ouverture numérique puisque l'on travaille à diamètre identique). Cependant, cela ne peut être réalisé que si la lentille ne présente pas trop de pertes optiques, donc ne permet pas d'envisager des solutions à base de lentilles de Fresnel à micro-prismes ouvertes. Les micro-prismes d'une lentille de Fresnel doivent être plus inclinés, notamment en périphérie. La dispersion chromatique est alors plus importante, entraînant des pertes d'efficacité optique, sans compter la difficulté de réalisation des zones extrêmes et les réflexions internes.

Un second paramètre majeur à prendre en compte est l'aspect thermique. Sous concentration, il est nécessaire de coupler à la cellule un système de management thermique de façon à maintenir une température compatible avec la température nominale d'utilisation de la cellule et ne pas dégrader son rendement. Cet aspect peut s'avérer être un paramètre limitant pour certaines applications.

Suite au succès des modules photovoltaïques à concentration CPV, dans le domaine terrestre, associant une cellule CV multijonction à fort rendement et un système de concentration, des études plus récentes ont vu le jour dans le domaine spatial.

Dans le domaine spatial, le besoin est formulé au niveau des panneaux solaires utilisés pour les générateurs solaires des satellites, pour lesquels on cherche à augmenter le rendement comme dans le domaine terrestre, néanmoins, les enjeux sont différents de ceux des applications terrestres.

D'une part, les conditions environnementales sont différentes, la compacité et le poids deviennent des critères beaucoup plus importants que dans le domaine terrestre, alors que le coût du module en lui-même devient un critère moindre.

D'autre part, les facteurs de concentration recherchés sont plus faibles que dans les applications terrestres car liés à un système de tracking devant être plus tolérant angulairement à cause de leur utilisation notamment en orbite géostationnaire. On rencontre des contraintes de management thermique différentes de celles rencontrées dans le domaine terrestre.

Enfin de nouveaux critères entrent en jeu comme la compatibilité avec les systèmes de déploiement des panneaux.

Aujourd'hui, deux types de solutions de concentration ont été explorés pour les applications dans le domaine spatial :

- des solutions en transmission (typiquement avec lentilles de Fresnel) ;
- des solutions en réflexion (systèmes à miroir) mais s'avérant peu efficaces car elles présentent des dégradations de performances liées à la contamination des miroirs en environnement spatial.

Une comparaison des effets de défaut de surface des concentrateurs en transmission et en réflexion est notamment décrite dans l'article : « Ultra-light streched Fresnel lens solar concentrator for space power applications », SPIE 48th Annual meeting, San Diego paper 5179-17 (2003).

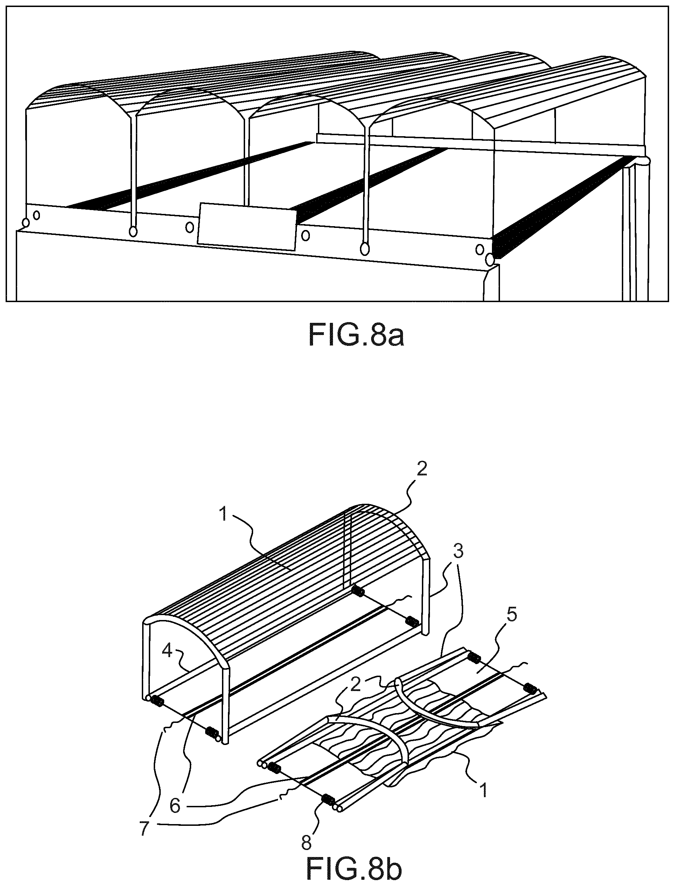

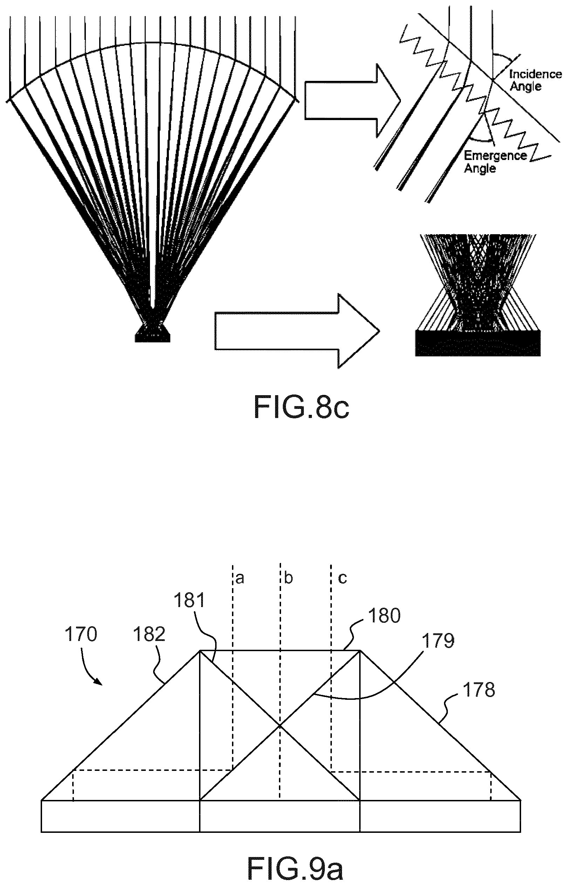

Il y est mentionné une configuration en transmission, illustration du concept « SLA Stretched Lens Array » et comportant des lentilles de Fresnel cylindriques flexibles fabriquées en polymère silicone, déployées et tenues par les arches qui mettent en tension les lentilles selon la direction de leur plus grande dimension, comme illustré en figures 8a, 8b et 8c. Plus précisément :

- la figure 8a représente une vue générale ;
- la figure 8b illustre les deux positions du concentrateur, le schéma inférieur de la figure : la position du concentrateur en position de stockage et pendant le lancement du satellite, le schéma supérieur : la position après déploiement des panneaux et déploiement des lentilles (brevet Entech : US 6 075 200, « Streched Fresnel lens concentrator for spacer power", Entech 2000) ;
- la figure 8c illustre une coupe de la lentille étirée après déploiement du concentrateur : « Ultra-light streched Fresnel lens solar concentrator for space power applications », SPIE 48th Annual meeting, San Diego paper 5179-17 (2003).

La solution en transmission proposée par la société Entech (US), comprend des cellules triple jonctions combinées avec des lentilles cylindriques obtenues par étirement d'un film de silicone. Les lentilles recourbées sont en fait constituées d'une lentille, permettant la fonction de concentration géométrique, combinée avec des micro-prismes permettant de corriger les aberrations chromatiques (en contrôlant la focalisation des rayons en fonction de la longueur d'onde). L'angle de chaque prisme est déterminé de façon à minimiser les aberrations chromatiques. Notons que cette optimisation de l'efficacité est également facilitée par le fait que la taille de la cellule est relativement grande (faible facteur de concentration).

D'un point de vue opérationnel, après lancement du satellite, ce système est déployé en deux étapes :

- une première étape correspondant au déploiement des panneaux solaires ;
- une seconde étape correspondant au déploiement des concentrateurs grâce à un système mécanique de courbure, cette dernière étape pouvant constituer un risque important de mauvais déploiement (donc une non-opérationnalité des panneaux et donc du générateur solaire) et qui nécessite une phase de qualification terrestre particulièrement couteuse en moyen d'essais.

De manière générale, Il est à noter que les techniques de concentration peuvent être également combinées avantageusement à des techniques de séparation spectrale, consistant à séparer spatialement (latéralement) le spectre solaire, comme dans l'approche proposée par le Centre Spatial de Liège (CSL) et décrit dans l'article de : C. Michel et al., "Study of solar concentrator for space, based on a diffractive/refractive combinaison", "Renewable Energy and the Environment, OSA, SM2A2 (2012).

En utilisant des modules multijonctions pour leur large spectre de sensibilité en longueur d'onde, des limitations liées à ce type de modules doivent néanmoins être surmontées. Les deux limitations principales de modules multijonctions sont en effet les suivantes :

- la condition d'accord de maille entre les matériaux aux interfaces entre les jonctions (qui conduit à réduire l'efficacité intrinsèque des matériaux quand on les empile). La première limitation restreint le choix de matériaux et donc limite la mise en oeuvre dans une meilleure combinaison en terme d'efficacité ;
- la condition d'adaptation de courant : les jonctions étant connectées en série, la jonction la moins efficace limite le courant pour l'ensemble de jonctions. De plus, du fait de la dépendance des différentes jonctions entre elles, la structure multijonction est plus sensible à des changements non calibrés du spectre ou à un vieillissement d'une jonction.

En utilisant des jonctions simples différentes, et avec des techniques de séparation spectrale latérale, on peut obtenir les avantages combinés suivants :

- un meilleur rendement théorique via :

    ◦ la suppression des pertes d'adaptation liées aux interfaces entre les jonctions;
    ◦ la possibilité d'utiliser différents matériaux, possiblement mieux adaptés au spectre ;
    ◦ la possibilité de mettre en oeuvre un antireflet de meilleure performance car optimisé sur chaque jonction horizontale ;
    ◦ une température de fonctionnement plus faible grâce à la répartition sur une plus grande surface du flux concentré permettant de relâcher des contraintes au niveau du management thermique, donc de réduire le coût de ce dernier et de fonctionner à efficacité optimale.

- un flux lumineux sur une surface plus grande (trois fois plus grande dans le cas de trois jonctions séparées horizontalement (ou latéralement) par rapport à une triple jonction verticale), permettant soit de faciliter le management thermique qui est un point essentiel notamment pour les applications spatiales à faible concentration ou pour les applications terrestres forte concentration, soit de maintenir le management thermique initial et utiliser les cellules à plus faible température et donc offrant un meilleur rendement ;
- l'utilisation de plusieurs cellules disposées horizontalement permet de multiplier le nombre de jonctions dans le plan horizontal, pour un meilleur rendement. Ceci n'est pas le cas d'une multijonction verticale où le nombre de jonctions devient limité à cause des conditions d'adaptation de maille. Elle permet également d'adapter la surface des jonctions les unes indépendamment des autres (puisqu'elles sont réparties horizontalement) pour capter plus de flux sur les cellules à rendement plus faibles, de façon à uniformiser les efficacités des différentes jonctions pour un montage en série optimal et éviter que la moins efficace des jonctions ne limite le courant pour l'ensemble des jonctions.

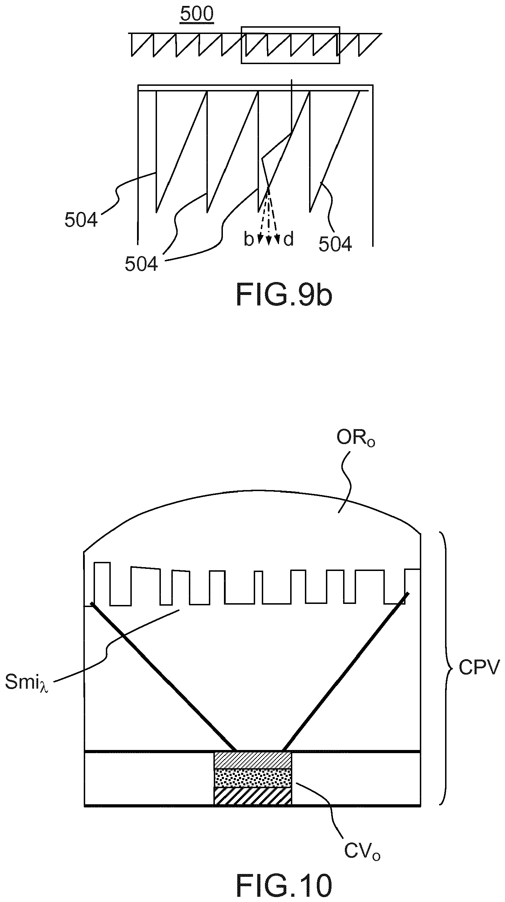

D'un point de vue technologique, des solutions de séparation spectrale ont été publiées/brevetées et utilisent des micro-prismes réfractifs essentiellement. Des exemples d'architectures pour la séparation spatio-chromatique sont décrits dans la demande de brevet US 2014 0130855 "dispersive optical systems and methods and related electricity génération systems and methods"; et dans US 2012 0312351 « efficient solar energy concentrator with improved thermal management » figure 9a : architecture dans la projection et figure 9b : architecture de prismes.

Dans ce contexte complexe d'intégration de nombreux paramètres, la présente invention a pour objet un module photovoltaïque à fortes performances, faible encombrement et adapté à des applications aussi bien terrestres que spatiales. Le module photovoltaïque de l'invention présente une grande compacité et une grande efficacité permettant d'améliorer davantage les performances des solutions de l'art antérieur et notamment pour des applications dans le domaine spatial permettant de ne pas nécessiter plusieurs opérations successives de déploiement dans l'espace de panneaux solaires et de concentrateurs, comme dans l'art antérieur.

Plus précisément la présente invention a pour objet un module photovoltaïque comprenant au moins une cellule photovoltaïque et au moins un dispositif optique de concentration, destiné à être illuminé par un flux lumineux émettant à au moins une longueur d'onde d'illumination $\lambda i$ appartenant à une bande de longueurs d'onde définie par une longueur d'onde minimale $\lambda_{min}$ et une longueur d'onde maximale $\lambda_{max}$, ladite bande de longueurs d'onde étant celle du rayonnement solaire de l'ordre de [380nm-1600nm], caractérisé en ce que :

- ledit dispositif optique de concentration est un composant monolithique et comprend au moins une structure diffractive comportant des motifs sub-longueur d'onde, définis dans un matériau dit structuré ;
- lesdits motifs ayant au moins une dimension inférieure ou égale à la longueur d'onde moyenne d'illumination $\lambda_c$ située entre $\lambda_{min}$ et $\lambda_{max}$ divisée par l'indice de réfraction dudit matériau structuré ;
- lesdits motifs étant séparés entre eux par des distances sub-longueurs d'onde définies entre centres de motifs adjacents ;
- ledit dispositif optique de concentration assurant au moins une fonction de focalisation et une fonction de diffraction.

Selon une variante de l'invention, ladite structure diffractive comprend des motifs sub-longueurs d'onde présentant des distances définies entre centres de motifs adjacents, périodiques.

Selon une variante de l'invention, le dispositif optique de concentration comprend deux structures diffractives comportant des motifs sub-longueur d'onde, définis dans au moins un matériau dit structuré, dont l'une assure une fonction de focalisation.

Selon une variante de l'invention, le dispositif optique de concentration comprend deux structures diffractives sur chacune de ses faces.

Selon une variante de l'invention, le dispositif optique de concentration comporte une structure diffractive comportant des motifs sub-longueur d'onde et une optique réfractive.

Selon une variante de l'invention, l'optique réfractive comporte au moins une lentille réfractive de surface courbe.

Selon une variante de l'invention, l'optique réfractive comprend au moins une lentille de Fresnel comportant un ensemble de micro-prismes de taille d'environ une à quelques centaines de microns.

Par exemple ces micro-prismes peuvent avoir une dimension comprise entre 1.3 mm et $110\mu$m sur une épaisseur de $20\mu$m. Lesdits microprismes peuvent avoir la même largeur mais présenter des hauteurs différentes, une largeur typique des micro-prismes peut être de l'ordre de $100\mu$m pour une focale de 5mm.

Selon une variante de l'invention, l'optique réfractive est réalisée dans le même matériau que le matériau structuré comportant lesdits motifs de dimensions sub-longueur d'onde.

Selon une variante de l'invention, les motifs sont des piliers ou des trous.

Selon une variante de l'invention, le dispositif de concentration comprend une structure diffractive avec des motifs de dimensions sub-longueur d'onde définis dans un matériau dit structuré présentant une fonction de correction d'aberration longitudinale et/ou une fonction de séparation spectrale latérale.

Selon une variante de l'invention, le dispositif de concentration comprend une zone centrale et des zones externes ;

- chaque zone étant composée de motifs de type piliers à section ronde ou carrée et/ou trous à section ronde ou carrée ;
- les dimensions desdits motifs variant d'une zone à l'autre de façon à coder une variation de l'indice effectif et donc une variation de phase, lesdites variations de dimension pouvant être monotones ou non.

Selon une variante de l'invention, les motifs présentent des dimensions latérales inférieures ou égales à 350nm et l'espacement entre le centre de deux motifs consécutifs étant d'environ 350nm et de hauteur de l'ordre de 1 à quelques microns.

Selon une variante de l'invention, ladite cellule photovoltaïque comprend un empilement de matériaux , réalisant une structure multijonction dite verticale, chacun desdits matériaux étant au moins sensible dans une sous-bande de longueurs d'onde, appartenant à ladite bande de longueurs d'onde, $\Delta\lambda = [\lambda_{min} ; \lambda_{max}]$.

Selon une variante de l'invention, ladite cellule photovoltaïque comprend un ensemble de sous-cellules élémentaires adjacentes photovoltaïques dans un même plan comprenant des matériaux sensibles dans des sous-bandes de longueurs d'onde, appartenant à ladite bande de longueurs d'onde $\Delta\lambda = [\lambda_{min} ; \lambda_{max}]$, de manière à constituer une structure multijonction dite horizontale.

Selon une variante de l'invention, le module photovoltaïque comprend des sous-ensembles de cellules élémentaires photovoltaïques, situés dans des plans différents.

Selon une variante de l'invention, le module photovoltaïque comprend des sous-cellules élémentaires photovoltaïques présentant des tailles différentes les unes par rapport aux autres.

Selon une variante de l'invention, l'optique réfractive est réalisée dans le même matériau que le matériau structuré comportant lesdits motifs de dimensions sub-longueur d'onde.

Selon une variante de l'invention, ledit matériau structuré est un diélectrique type silice, verre, $Si_3N_4$, ou en matériau polymérique pouvant être du polydiméthylsiloxane (PDMS), ou du polyméthacrylate de méthyle (PMMA), ou du polycarbonate (PC).

Selon une variante de l'invention, les dimensions des motifs sont inférieures ou égales à 350nm en largeur et de l'ordre de 1 à $2\mu$m en hauteur.

Selon une variante de l'invention, les dimensions des motifs sont de l'ordre de 80nm à 250nm en largeur ou en diamètre, de 1 à $2\mu$m en hauteur.

Selon une variante de l'invention, les motifs sont des trous et des piliers.

Selon une variante de l'invention, le module photovoltaïque à concentration comprend un ensemble de cellules élémentaires photovoltaïques.

Selon une variante de l'invention, le dispositif optique de concentration comprend un ensemble de micro-lentilles, chaque micro-lentille étant couplée à une structure diffractive comportant des motifs de dimensions sub-longueur d'onde.

Selon une variante de l'invention, le dispositif optique de concentration comprend un ensemble de lentilles de Fresnel à micro-prismes, chaque lentille de Fresnel étant couplée à une structure diffractive comportant des motifs de dimensions sub-longueur d'onde.

L'invention a aussi pour objet un panneau solaire pour générateur solaire pour satellite comprenant au moins un module photovoltaïque selon l'invention.

L'invention sera mieux comprise et d'autres avantages apparaîtront à la lecture de la description qui va suivre, donnée à titre non limitatif et grâce aux figures parmi lesquelles :

- la figure 1 schématise un module photovoltaïque de l'art connu comprenant une cellule photovoltaïque et une optique de concentration ;
- les figures 2a et 2b illustrent respectivement une cellule photovoltaïque comprenant une structure multijonction de matériaux empilés et un module intégrant ladite cellule ;
- la figure 3 illustre différentes solutions de concentrateurs optiques fonctionnant en transmission, proposées dans l'art antérieur et intégrées à des modules photovoltaïques ;
- la figure 4 illustre une structure de lentille de Fresnel comprenant des micro-prismes ;
- les figures 5a et 5b illustrent l'effet chromatique d'une lentille de Fresnel diffractive, sur l'efficacité de ladite lentille pour deux positions différentes de la lentille par rapport à la cellule ;
- la figure 6 illustre différentes solutions de concentrateurs optiques fonctionnant en réflexion, proposées dans l'art antérieur et intégrées à des modules photovoltaïques ;
- les figures 7a, 7b et 7c illustrent les contraintes géométriques liées à la dimension angulaire du soleil $\theta s$ et l'angle d'acceptance $\alpha$ du dispositif, selon trois configurations différentes ;
- les figures 8a, 8b, 8c illustrent une configuration de module photovoltaïque pour application spatiale proposée dans l'art antérieur ;
- les figures 9a et 9b illustrent des exemples d'architecture de séparation spatio-chromatiques selon l'art connu ;
- la figure 10 schématise un module photovoltaïque selon l'invention ;
- la figure 11 schématise une variante de l'invention comprenant un ensemble de cellules CV à multijonctions verticales ;
- la figure 12 schématise une variante de l'invention comprenant un ensemble de cellules CV comprenant des sous-cellules élémentaires disposées latéralement ;
- les figures 13a et 13b illustrent une représentation simplifiée de l'effet d'ombrage et la chute de l'efficacité de diffraction en fonction de l'angle de déviation dans le cas d'optique de diffraction comprenant un réseau de microprismes ;
- la figure 14 illustre l'efficacité de diffraction dans le domaine scalaire d'une lentille en fonction du rapport de la longueur d'onde d'illumination sur la longueur d'onde de conception ;
- la figure 15 illustre le comportement spectral de composants sub-longueur d'onde en comparaison avec celui d'une lentille diffractive classique en échelette ;
- la figure 16 illustre le spectre solaire type AM1.5 correspondant au spectre solaire après traversée de l'atmosphère, le soleil faisant un angle de 48° environ par rapport à sa position au zénith ;
- la figure 17 illustre un exemple de dispositif optique de concentration comprenant un réseau sub-longueur d'onde de type distributeur;
- la figure 18 illustre un exemple de dispositif optique de concentration utilisé dans une variante de module photovoltaïque de l'invention ;
- la figure 19 illustre une seconde variante de l'invention de module photovoltaïque de l'invention intégrant une fonction de focalisation dans une structure diffractive sub-longueur d'onde ;
- les figures 20a et 20b illustrent un exemple de dispositif optique de concentration utilisé dans l'invention incluant une fonction de séparation spectrale ;
- les figures 21a et 21b illustrent un exemple de dispositif optique de concentration utilisé dans l'invention incluant une fonction de correction d'aberrations longitudinales ;
- la figure 22 illustre un exemple de variation d'indice effectif avec la largeur des motifs, utilisée dans l'exemple de dispositif optique de concentration illustré en figures 21a et 21b ;
- les figures 23a, 23b et 23c illustrent un dispositif optique de concentration comprenant une structure diffractive assurant une fonction de focalisation et une structure diffractive assurant une fonction de séparation spectrale ;
- la figure 24 illustre un dispositif optique de concentration comprenant une unique structure diffractive assurant une fonction de focalisation et une fonction de séparation spectrale.

La présente invention a pour objet un module photovoltaïque comprenant au moins une cellule photovoltaïque et un dispositif optique de concentration comprenant une structure comportant des motifs sub-longueur d'onde, définis dans un matériau dit structuré, dont au moins une dimension desdits motifs est inférieure à ladite longueur d'onde moyenne d'illumination$(\lambda_c)$ divisée par l'indice de réfraction dudit matériau structuré, ledit dispositif optique de concentration assurant au moins une fonction de focalisation et une fonction de diffraction.

La fonction de focalisation est assurée par une optique réfractive de type lentille associée à une structure diffractive comprenant les motifs sub-longueur d'onde, définis dans un matériau dit structuré dont au moins une dimension desdits motifs est inférieure à ladite longueur d'onde d'illumination moyenne sur spectre d'illumination $(\lambda_c)$ divisée par

l'indice de réfraction dudit matériau structuré

La figure 10 schématise une variante de module photovoltaïque de la présente invention CPV$_o$, comportant une cellule photovoltaïque CV$_o$ et un dispositif optique de concentration encore appelé concentrateur comprenant la structure diffractive Smi$_\lambda$ comprenant des motifs sub-longueur d'onde, associée à une structure réfractive OR$_o$ présentant une surface courbe. Le flux solaire FLs est capté par la cellule photovoltaïque composée de multi-jonctions verticales.

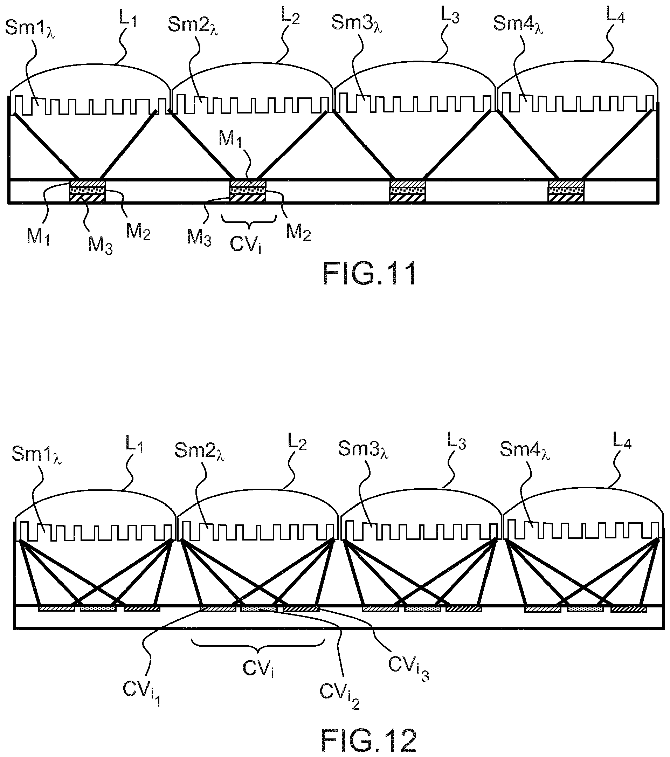

La figure 11 schématise une variante de module photovoltaïque de la présente invention comportant un ensemble de cellules photovoltaïques, couplées à un ensemble de dispositifs optiques de concentration, lesdites cellules comprenant avantageusement des structures multijonctions verticales précédemment décrites et constituées par exemple de 3 matériaux sensibles dans des bandes de longueurs d'onde différentes.

Plus précisément, chaque cellule CVi comporte un empilement de trois matériaux sensibles dans des bandes de longueurs d'onde différentes, M1, M2 et M3 respectivement sensibles dans les bandes de longueurs d'onde $\Delta\lambda_1$, $\Delta\lambda_2$ et $\Delta\lambda_3$. Le dispositif optique de concentration comprend un ensemble de microlentilles L$_1$, L$_2$, L$_3$, L$_4$ et un ensemble de structures de motifs sub-longueurs d'onde Sm$_{1\lambda}$, Sm$_{2\lambda}$, Sm$_{3\lambda}$, Sm$_{4\lambda}$.

La figure 12 schématise une variante de module photovoltaïque de la présente invention comportant un ensemble de cellules photovoltaïques, couplées à un ensemble de dispositifs optiques de concentration, chaque cellule CVi comportant un ensemble de sous-cellules à jonction simple CVij disposées latéralement, chacune des trois sous-cellules représentées comprenant un matériau sensible dans une bande de longueurs d'onde différente de celles des autres sous- cellules appartenant à la même cellule. Plus précisément, chaque cellule CVi comporte un ensemble de trois sous-cellules (sont représentées , trois sous-cellules CVi$_1$, CVi$_2$, CVi$_3$) comportant trois matériaux photo sensibles dans des bandes de longueurs d'onde différentes, M1, M2 et M3 respectivement sensibles dans les bandes de longueurs d'onde $\Delta\lambda_1$, $\Delta\lambda_2$ et $\Delta\lambda_3$. Le dispositif optique de concentration comprend un ensemble de microlentilles L$_1$, L$_2$, L$_3$, L$_4$ et un ensemble de structures associées de motifs sub-longueurs d'onde Sm$_{1\lambda}$, Sm$_{2\lambda}$, Sm$_{3\lambda}$, Sm$_{4\lambda}$

Les intérêts, performances et fonctionnalités des optiques sub-longueur d'onde sont détaillées ci-après. De manière générale, les optiques sub-longueur d'onde constituent une famille d'optiques composées de structures binaires (réalisées à l'aide d'un seul niveau de masquage) de taille inférieure à la longueur d'onde gravées dans un matériau diélectrique dont le principe est basé sur la synthèse de matériau artificiel. Typiquement, en partant d'une structure périodique de période inférieure à la longueur d'onde d'illumination moyenne du spectre divisée par l'indice du matériau structuré, il est possible de synthétiser n'importe quelle distribution d'indice effectif, et donc n'importe quelle distribution de phase, en contrôlant la taille des microstructures. Parmi les distributions de phases possibles, figure celle d'un composant diffractif tel qu'un réseau de diffraction ou une lentille de diffraction aussi dite de Fresnel diffractive (basée sur la loi de diffraction, et sur des sauts de phase de 2pi ou de quelques modulo 2pi, à l'opposé des lentilles de Fresnel à micro-prismes dont le principe est basé sur la loi de la réfraction). Ces structures ont des propriétés particulières exploitables pour les applications d'optiques compactes efficaces, notamment à forte ouverture et/ou large bande spectrale.

De plus, de part la maîtrise technologique locale des tailles de structures, il est possible de contrôler l'énergie lumineuse diffractée dirigée dans des directions différentes en fonction de la longueur d'onde, visant les différentes cellules photosensibles, sensibles à différentes régions du spectre. Plus particulièrement, il est possible d'augmenter le flux lumineux arrivant sur certaines cellules photosensibles qui seraient moins efficaces, de façon à obtenir pour les différentes jonctions des efficacités quasi identiques et éviter que la plus faible efficacité de jonction ne limite le courant pour l'ensemble des jonctions, lié au montage en série. De la même façon, la conception du composant permet d'adapter la surface des jonctions (largeur de cellules différente) pour équilibrer l'efficacité des différentes jonctions les unes par rapport aux autres pour un montage en série optimal.

D'un point de vue technologique, cette famille d'optiques a pour avantage d'avoir un profil binaire : elle ne nécessite qu'une seule étape de lithographie, sans alignement de masques contrairement aux optiques multi·niveaux, ce qui réduit leur efficacité finale. Les profils sont compatibles de moyens de fabrication en volume comme le nanoimprint, le moulage ou l'embossage à chaud, et bien d'autres techniques, le master étant lui-même fabricable avec les moyens de l'industrie des semi·conducteurs (gravure ICP et lithographie électronique).

Ces technologies utilisent avantageusement des matériaux légers et transparents dans le visible tels que le polydiméthylsiloxane PDMS, le polyméthacrylate de méthyle PMMA, le polycarbonate PC .

Au niveau des performances, ces optiques présentent une capacité à adresser même des optiques à forte ouverture numérique comme décrit dans les articles de : Ph. Lalanne, S. Astilean, P. Chavel, E. Cambarnd H.Launois, "Blazed·binary subwavelength gratings with efficiencies larger than those of conventional échelette gratings". Opt. Lett. 23. 1081·1083 (1998) et de MS.L Lee, Ph Lalanne, J C. Rodier, P Chavel. E Cambril, Y Chen, "Imaging with blazed·binary diffractive elements", Opt. A : Pure Appl. Opt. Vol. 4,S119 (2002).

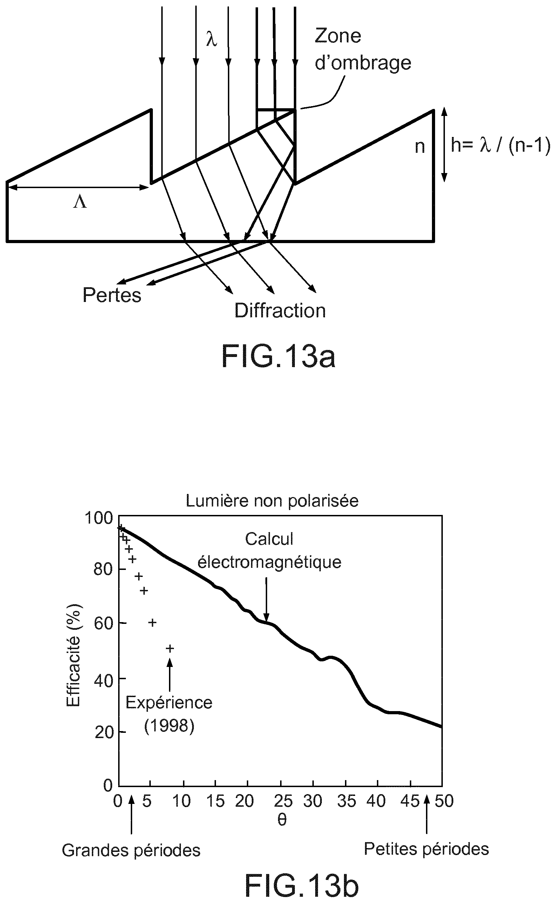

Elles sont particulièrement intéressantes pour la compacité des dispositifs, ce qui est difficile dans le cas des optiques diffractives classiques, comme le montrent les figures 13a et 13b qui illustrent respectivement une représentation simplifiée de l'effet d'ombrage par tracé de rayon et la chute de l'efficacité de diffraction en fonction de l'angle de déviation d'un réseau de diffraction (équivalent au demi-angle d'ouverture d'une lentille). La ligne pointillée fournit la chute d'efficacité de diffraction théorique d'un réseau échelette gravé dans du verre (n=1.5).

En réalité, la chute d'efficacité de diffraction des lentilles diffractives classiques aux fortes ouvertures est encore plus importante de façon expérimentale car il est difficile de réaliser les sauts de $2\pi$ avec une transition abrupte.

De plus, les optiques sub-longueur d'onde présentent des propriétés de dispersion unique, ce qui permet de les faire travailler effectivement sur une large bande spectrale. Typiquement en structurant un matériau d'AsGa, une dispersion de l'indice de réfraction permet d'atteindre une variation $\Delta n = 0.36$ sur la bande 8-12 $\mu$m par rapport à une valeur de 0.02 pour un matériau non structuré. Grâce à cette propriété de dispersion de l'indice effectif, il est possible de concevoir des optiques diffractives dont l'efficacité est maintenue sur une large bande, comme décrit dans l'article de C. Sauvan, Ph.Lalanne, M-S. L. Lee, "Broadband blazing with artificial dielectrics", Opt. Lett. 29, 1593-1595 (2004), dans la demande de brevet US 2007/0103782, dans l'article de C. Ribot, PhD Thesis from University of Paris Sud (2008) ou dans celui de M-S. L. Lee, S. Bansropun, O. Huet, S. Cassette, B. Loiseaux, A. P. Wood, C. Sauvan and P. Lalanne, "Sub-wavelength structures for broadband diffractive optics", ICO 2005, 0602-34 (2005).

Cette propriété est très intéressante pour les applications solaires pour lesquelles le spectre est très large typiquement [380nm-1600nm].

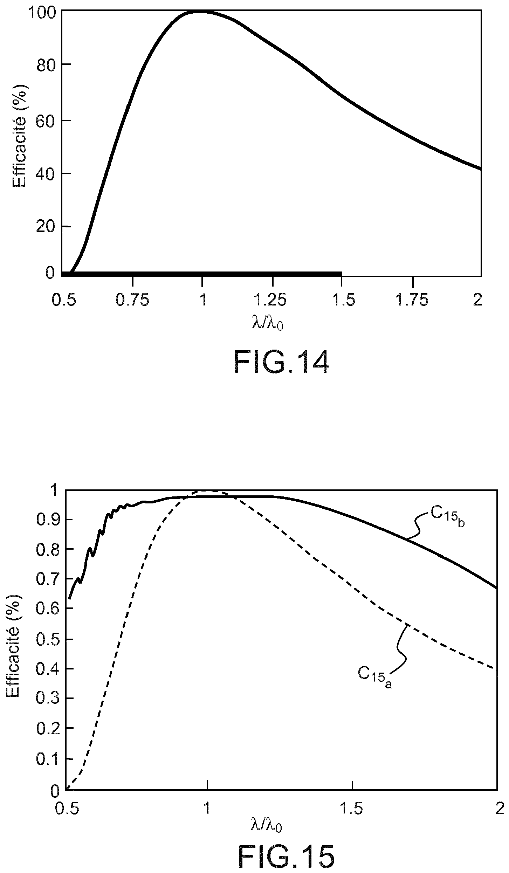

Par exemple, en concevant une lentille diffractive classique en échelette à $\lambda_0 = 800$ nm, l'intervalle spectral est alors compris entre 0.5 $\lambda_0$ et 2 $\lambda_0$ comme illustré sur la figure 14 qui donne l'efficacité de diffraction dans le domaine scalaire de cette lentille en fonction du rapport de la longueur d'onde d'illumination sur la longueur d'onde de conception $\lambda/\lambda_0$. Même s'il est possible d'ajuster la longueur d'onde de design pour équilibrer les pertes spectrales, la chute d'efficacité reste importante.

A titre de comparaison, la figure 15 illustre le comportement spectral de composants sub-longueur d'onde en comparaison avec celui d'une lentille diffractive classique en échelette. Il apparaît que le gain sur la bande est significatif. Plus précisément cette figure illustre le comportement de l'efficacité de diffraction d'une optique diffractive classique en échelette (traits pointillés, courbe $C_{15a}$) et d'une optique sub-longueur d'onde (traits continus, courbe $C_{15b}$) en fonction de la longueur d'onde d'illumination ($\lambda_0$ étant la longueur d'onde de conception), dans le domaine scalaire.

D'autre part, avec ces optiques, la capacité de contrôler la phase en contrôlant la taille des structures permet non seulement de synthétiser une optique optimisée à une ou plusieurs longueurs d'onde, mais également d'ajuster ou de répartir à la demande, l'intensité des différents ordres de diffraction, ce qui est utile dans le cas de la séparation spectrale, où l'intensité lumineuse reçue n'est pas la même à l'intérieur du spectre.

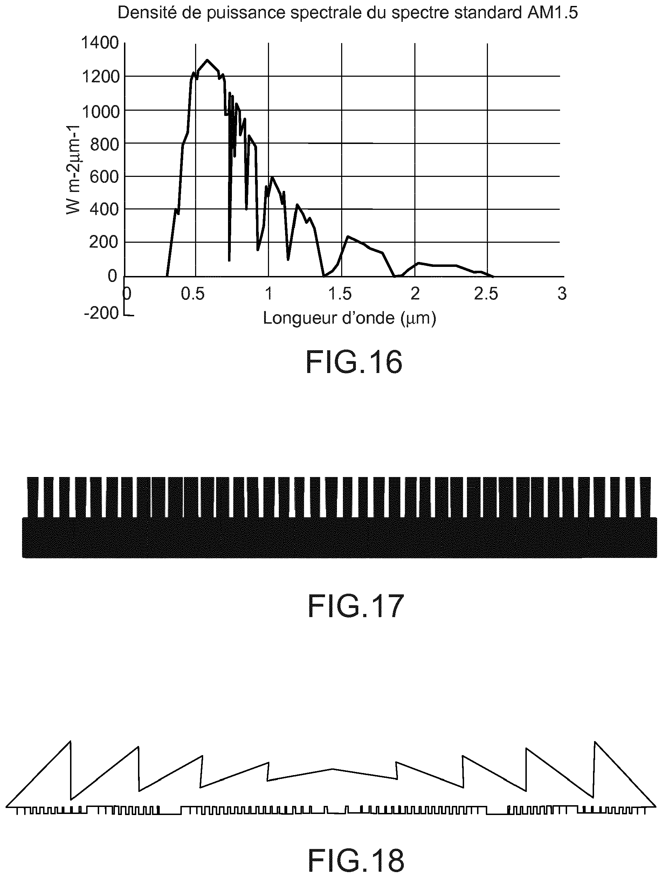

Un exemple de spectre solaire type AM1.5 est donné en figure 16, le spectre solaire AM1.5 correspondant au spectre solaire après traversée de l'atmosphère, le soleil faisant un angle de 48° environ par rapport à sa position au zénith.

Un exemple d'application de ces composants est celui de la fonction diffractive dans un système achromatique réfractif/diffractif, de façon à non seulement achromatiser la focale (fonction diffractive), mais aussi à achromatiser l'efficacité de diffraction. Ainsi, par rapport à une solution réfractive pure (approche de la lentille de Fresnel réfractive à micro-prismes), on obtient un meilleur rendement lié à un repliement du chromatisme longitudinal de la focale sans souffrir des pertes de l'efficacité de diffraction large bande d'une lentille diffractive classique.

Un autre exemple dans l'utilisation de ces optiques est la séparation spectrale. On peut les utiliser en tant que réseau blazé, utilisant l'ordre 0 pour l'infrarouge et l'ordre 1 pour le Visible et le proche IR, comme dans l'approche proposée par le Centre Spatial de Liège (CSL) et décrit dans l'article de : C. Michel et al., "Study of solar concentrator for space, based on a diffractive/refractive combinaison", "Renewable Energy and the Environment, OSA, SM2A2 (2012).

Un des intérêts de la solution de la présente invention réside ainsi dans une efficacité de diffraction plus large spectralement sans affecter l'efficacité à la longueur d'onde de conception (c'est-à-dire ayant la meilleure efficacité) ou celle à la longueur d'onde moyenne, même en présence d'un système compact avec un angle de déviation de l'ordre 1 plus grand (typiquement dans le cas d'une concentration x 10, et d'une distance focale de 5mm), ce qui n'est pas le cas avec un réseau échelette classique.

Dans une variante de l'invention, le dispositif optique de concentration peut comprendre un réseau sub-longueur d'onde de type « distributeur », pour lequel le choix des tailles de structures sub-longueur d'onde le constituant permet de faire de l'ingénierie des angles et ordres de diffraction pour distribuer/répartir l'énergie spatialement et spectralement sur des cellules simples jonctions disposées latéralement.

Dans une variante de l'invention, les cellules simple jonctions disposées latéralement peuvent être ou non au même niveau horizontalement.

Dans une variante de l'invention, les cellules simple jonctions disposées latéralement peuvent être ou non de même taille.

Des études ont démontré la capacité des composants sub-longueur d'onde de type « distributeur » pour séparer latéralement différents ordres de diffraction avec des efficacités contrôlées pour une application de séparateur de faisceau comme décrit dans l'article de G. Bloom, Ch. Larat, E. Lallier, M-SL. Lee-Bouhours, B. Loiseaux, J-P. Huignard, "Design and optimization of a high efficiency array generator in the mid-IR with binary subwavelength grooves", Appl. Opt. 50,701-709 (2011) et la thèse Guillaume Bloom : « Combinaison cohérente de lasers à cascade quantique" soutenue le 14 février 2012, Université PARIS XI ORSAY. La figure 17 illustre un exemple de réseau sub-longueur d'onde de type « distributeur » permettant de créer plusieurs ordres de diffraction avec des énergies contrôlées. Dans le cas des documents cités, le réseau avait pour but de produire des ordres diffractés avec des énergies quasi-égales, mais ce concept s'applique aussi pour produire des ordres de diffraction avec la distribution désirée d'énergie selon les ordres de diffraction

La solution de la présente invention est particulièrement intéressante pour des applications spatiales. En effet, le dispositif de l'invention est un système statique, ne nécessitant pas d'étape de déploiement des concentrateurs (détaillée précédemment dans une solution de l'art antérieur) et reste compatible avec un système de tracking pour satellite (typiquement de l'ordre de 3° pour une focale de 5mm, pour un taux de concentration de 12) En proposant une solution bien compacte, il est également possible de réduire le volume des panneaux et de simplifier la solution et les moyens de tests au sol à mettre en oeuvre avant le lancement du satellite.

Par ailleurs, le dispositif de l'invention est basé sur l'utilisation d'optiques sub-longueur d'ondes pouvant être réalisées dans des matériaux légers permettant de synthétiser des optiques planaires efficaces à plus courte focale.

La solution peut également être combinée à une technique de séparation spectrale, pour accroître l'efficacité de conversion des cellules.

Le demandeur a ainsi résolu les problèmes suivants :

- avoir un système compact, donc une distance de focalisation courte, typiquement inférieur au centimètre jusqu'à quelques millimètres par exemple ou moins, et des composants peu encombrants ;
- combiner une fonction de focalisation et une fonction de correction de chromatisme ;
- assurer une bonne efficacité du concentrateur sur tout le spectre adressé, en proposant d'associer une fonction de focalisation à très faible focale, avec une fonction diffractive à ouverture numérique plus faible que celle du composant réfractif

Les différentes fonctions apportées par les différents éléments de l'architecture sont :

- une compacité grâce à l'utilisation de micro-lentilles et d'optiques sub-longueur d'onde ;
- une meilleure efficacité optique de concentration sur la cellule photovoltaïque par la combinaison réfractive-diffractive, qui permet une meilleure achromatisation longitudinale par compensation de l'écart entre $f(\lambda_m)$ et $f(\lambda_M)$. A titre d'exemple, un écart initial de $\sim 350\mu m$ environ entre $f(\lambda_m=350nm)$ et $f(\lambda_M=1400nm)$, pour un système ouvert à f/D=1, et f=5mm, est ramené à quasiment 0 entre ces deux longueurs d'onde grâce à l'achromatisation longitudinale. De façon plus précise à l'intérieur de l'intervalle $[\lambda_m ; \lambda_M]$ la variation de la focale est réduite d'au moins un facteur 3.
- une meilleure efficacité spectrale en exploitant les propriétés large bande des optiques sub-longueur d'onde.

Selon une variante de l'invention, et ce pour obtenir un système encore plus compact, le dispositif optique de concentration peut comprendre un système type lentille de Fresnel réfractive à micro-prismes, combinée à une lentille diffractive sub-longueur d'onde, comme illustré en figure 18.

Selon cet exemple, le concentrateur hybride réfractif/diffractif comprend ainsi un composant réfractif composé de micro-prismes et un composant diffractif composé de structures sub-longueur d'onde.

Avantageusement, cette solution de concentration peut être combinée avec une technique de séparation spectrale, dont la fonction peut aussi être intégrée sur la face diffractive en même temps que la fonction de correction du chromatisme longitudinal. Le principe consiste à séparer latéralement les différents points de focalisation en fonction de la longueur d'onde du spectre solaire à l'aide d'une fonction réseau, intégrée sur le composant diffractif, utilisant des simples jonctions de matériau répartis latéralement et sensibles dans des bandes de longueurs d'onde différentes, comme décrit précédemment. L'avantage de la structure sub-longueur d'onde pour l'implémentation de la fonction de séparation spectrale est la possibilité d'ajuster l'énergie dirigée sur chacune des jonctions réparties latéralement et de permettre des surfaces de jonctions sensiblement différentes, pour une meilleure efficacité du montage en série, tout en maintenant une bonne efficacité de diffraction sur tout le spectre.

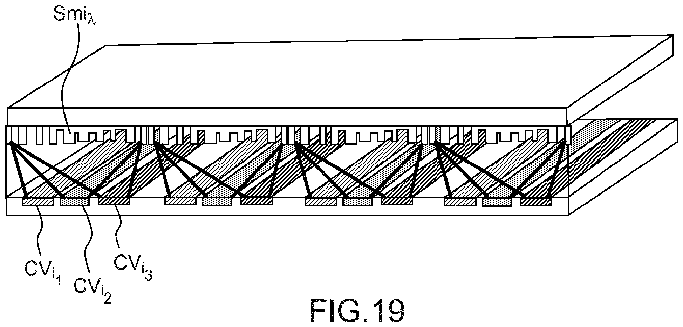

Selon une variante de l'invention, le module photovoltaïque peut comprendre un dispositif optique de concentration assurant une fonction de focalisation, tel qu'illustré en figure 19, un ensemble de cellules CVi, pouvant comporter des sous-ensembles de cellules CVij (CVi$_1$, CVi$_2$, CVi$_3$ représentées) telles que celles décrites dans la première variante de l'invention.

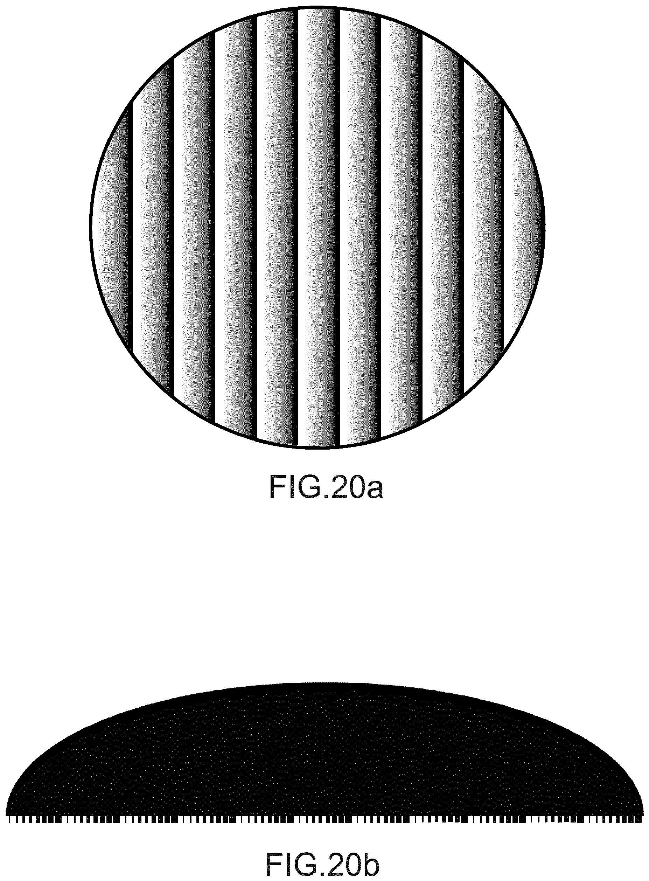

Selon une variante de l'invention, le module photovoltaïque peut comprendre un dispositif optique de concentration assurant une fonction de focalisation et une fonction de séparation spectrale, tel qu'illustré en figures 20a et 20b. Le dispositif optique de concentration synthétise la fonction de focalisation et la fonction séparation spectrale latérale, permettant ainsi d'obtenir un système très compact.

Le dispositif optique présente un taux de concentration C (pouvant être égal à 12, C=12), défini comme le diamètre du dispositif de concentration divisé par la largeur de la cellule.

En supposant l'utilisation de *Nbre$_{cellule}$* de sous-cellules élémentaires couplées au dispositif optique de concentration, sensibles à différentes régions du spectre solaire, juxtaposées les unes à côté des autres par lot, et de largeur de la cellule, la période du réseau est donné par la relation,

$$\Lambda = \frac{\lambda_{Max} - \lambda_{min}}{2\sin\left(a\tan\left(\dfrac{Nbre_{cellule}.D}{2f.C}\right)\right)}.$$

Pour un composant conçu dans son ordre 1 de diffraction, la période ne dépend que du rapport f/D et du taux de concentration et du nombre de « voies » spectrales ou de sous-cellules élémentaires par concentrateur.

Le tableau ci-dessous donne des exemples de structures, en supposant $Nbre_{cellule}$=3 et fournit des valeurs de périodes exprimées en microns, pouvant utiliser une lentille en silice ouverte à f/D=1 (focale/diamètre), par exemple avec un diamètre environ 5mm.

| C | f/D | Λ |
|---|---|---|
| 9 | 1 | 3 |
| 9 | 0.5 | 1.6 |
| 12 | 1 | 4 |
| 12 | 0.5 | 2.1 |
| 20 | 1 | 6.7 |
| 20 | 0.5 | 3.4 |

Les motifs de la structure diffractive présentent des largeurs comprises entre 0 et 240 nm et des hauteurs de 2 microns.

Selon une variante de l'invention, le dispositif optique de concentration utilisé dans la présente invention peut assurer également une fonction de corrections d'aberrations longitudinales.

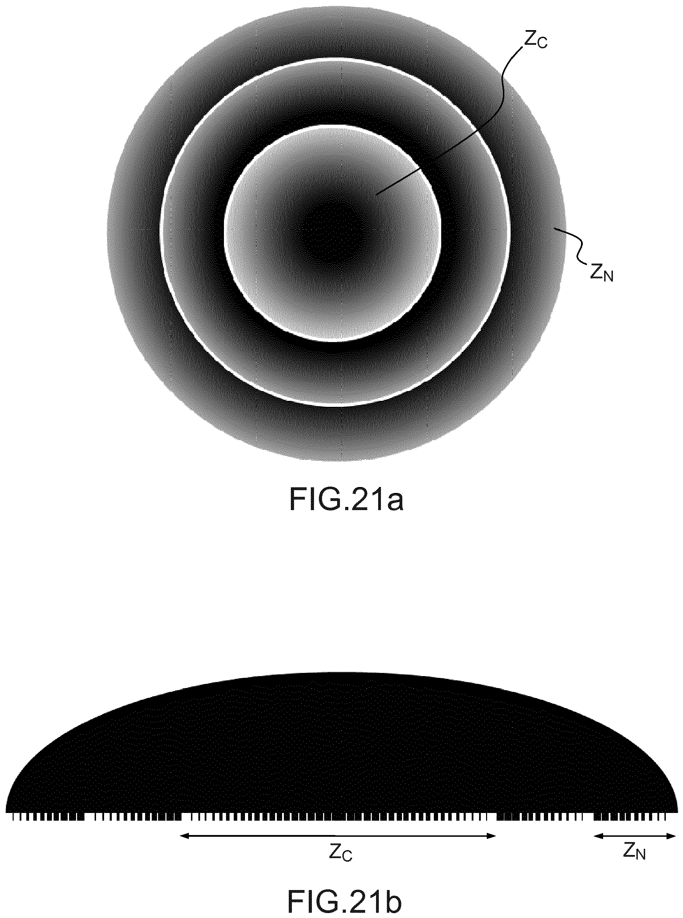

Un tel composant est illustré en figures 21a et 21b et présente une zone centrale $Z_c$ et des zones externes, seule la plus extérieure, référencée $Z_N$, est référencée sur les figures.

La hauteur des motifs $h_2$' est définie ci-après $h_2' = \dfrac{\lambda_0}{n_{Max}(\lambda_0) - n_{min}(\lambda_0)}$, où $n_{Max}(\lambda_0)$ et $n_{min}(\lambda_0)$ correspondent aux indices effectifs pour une structure diffractive composée de motifs sub-longueur d'onde pour un composant fonctionnant dans son ordre 1 de diffraction.

Typiquement $n_{Max}(\lambda_0)$-$n_{min}(\lambda_0)$ peut être égal à environ 0.5 pour un matériau type silice (n~1.5), et 1 pour un nitrure de silicium (n-2).

Ces valeurs sont calculées par une méthode de résolution du problème de diffraction dans un structure périodique infinie, appelée méthode modale de Fourier ou RCWA (Rigorous Coupled-Wave Analysis). Plus particulièrement, l'indice effectif dans la structure périodique est donné par l'indice effectif du mode de Bloch se propageant dans la structure sub-longueur d'onde.

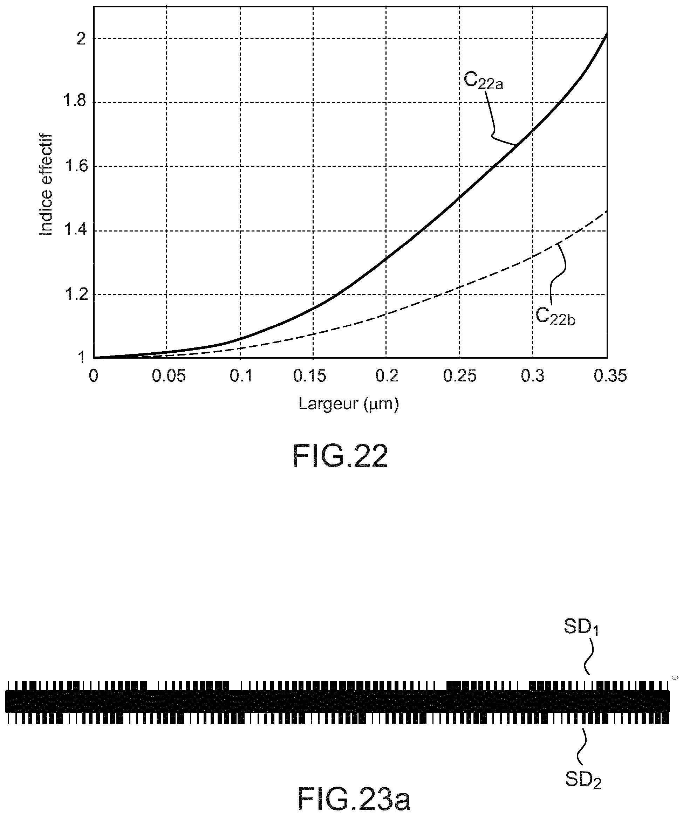

A titre d'exemple, la figure 22 donne les indices effectifs d'une structure sub-longueur d'onde périodique composée de piliers de section carrée, de période 350nm en fonction de la largeur des piliers, pour des piliers gravés dans du nitrure de silicium ou dans de la silice, pour une illumination à 800nm. La courbe $C_{22a}$ est relative au nitrure de silicium, la courbe $C_{22b}$ étant relative à la silice.

Le nombre de zones est donné par :

$$N = floor\left(\frac{D^2}{8fd_2.\lambda_0}\right),$$

où « floor » est la fonction « escalier », c'est-à-dire que floor (x) correspond à l'entier inférieur ou égal à x.

Le rayon de la zone centrale est égal à :

$$r_1 = \sqrt{2.fd_2.\lambda_0} \; .$$

La largeur de la zone n est donnée par n, compris entre 2 et N (le nombre maximum de zones):

$$\mathrm{larg}^n = r_n - r_{n-1} = \sqrt{2.fd_2.\lambda_0}.\left(\sqrt{n} - \sqrt{n-1}\right),$$

soit pour la dernière zone

$$\mathrm{larg}^N = r_N - r_{N-1} = \sqrt{2.fd_2.\lambda_0}.\left(\sqrt{N} - \sqrt{N-1}\right),$$

où $fd_2$ représente la focale du composant diffractif et dépend des constringences $v_1$ et $v_2$, respectivement du composant réfractif et diffractif qui constituent la lentille recherchée de focale f qui constitue le concentrateur.

Les constringences $v_1$ et $v_2$ dépendent essentiellement du matériau constituant le composant diffractif ainsi que des longueurs d'onde choisies par définition sur la bande considérée, ici $\lambda_{\min}$=400nm, $\lambda_{\mathrm{Max}}$=1400nm :

$$v_2 = \frac{\lambda_0}{\lambda_{\min} - \lambda_{\mathrm{Max}}}, \qquad fd_2 = -f.\frac{v_1 - v_2}{v_2},$$

$$v_1 = \frac{n(\lambda_0) - 1}{n(\lambda_{\min}) - n(\lambda_{\mathrm{Max}})}$$

| $\lambda$ | $\lambda_{\min}$=400n m | $\lambda_0$=800nm | $\lambda_{\mathrm{Max}}$=1400n m | 400nm-1400nm | |
|---|---|---|---|---|---|
| | $n(\lambda_{\min})$ | $n(\lambda_0)$ | $n(\lambda_{\mathrm{Max}})$ | $v_1$ | $v_2$ |
| silice | 1.4701 | 1.4533 | 1.4458 | 18.6543 | -0.8000 |
| Nitrure de silicium | 2.0739 | 2.0102 | 1.9924 | 12.3924 | -0.8000 |

La lentille réfractive du concentrateur est définie elle par sa focale $fd_1$ donnée par:

$$fd_1 = f.\frac{v_1 - v_2}{v_1} \; .$$

A titre d'exemple, en considérant une lentille en silice ouverte à f/D=1 (focale/diamètre), de diamètre environ 5mm, utilisée pour un taux de concentration x12. La lentille diffractive permettant de réduire l'aberration chromatique longitudinale peut être composée de différentes zones de Fresnel diffractives de hauteur typique de $2\,\mu$m environ pour une utilisation dans son ordre 1 de diffraction. La zone centrale est un disque de rayon $441\,\mu$m et la zone la plus externe est un anneau de $39\,\mu$m de largeur.

Les motifs de la structure diffractive présentent des largeurs comprises entre 0 et 240 nm et des hauteurs de 2 microns.

Selon une variante de l'invention, le dispositif optique de concentration peut comprendre deux structures diffractives sur chacune de ses faces dont une structure diffractive permettant d'assurer une fonction de focalisation et une structure diffractive assurant une fonction de séparation spectrale.

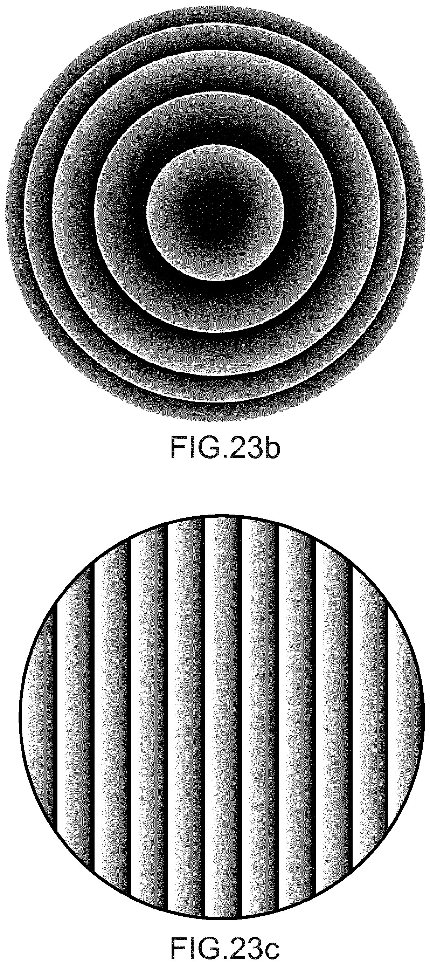

Les figures 23a, 23b et 23c illustrent ainsi un exemple de configuration composée d'une lentille diffractive de focalisation se trouvant sur une face et d'un réseau de diffraction pour la séparation spectrale se trouvant sur la deuxième face.

La figure 23a donne une vue simplifiée d'une coupe du composant suivant son diamètre avec une première structure diffractive $S_{D1}$ pour la focalisation et une seconde structure diffractive $S_{D2}$ pour la séparation spectrale.

La figure 23b donne une vue du dessus du composant, les niveaux de gris représentent une variation d'indice effectif codée grâce à des motifs sub-longueur d'onde. Les régions plus sombres correspondent à des niveaux d'indice effectif plus élevés. Les zones plus claires correspondent à des niveaux d'indice effectif plus faibles.

La figure 23c donne une vue du dessous du composant, les niveaux de gris représentent une variation d'indice effectif codée grâce à des motifs sub-longueur d'onde.

Dans cet exemple, le concentrateur est composé d'une lentille diffractive et d'un réseau de diffraction. Ces deux éléments se trouvent sur chacune des faces d'un seul composant qui sert à la fois de concentrateur et de séparateur spectral. Chaque fonction est réalisée à l'aide de motifs sub-longueur d'onde. Le calcul de la lentille diffractive, servant de fonction de focalisation est différent de celui de la lentille servant à réduire les aberrations chromatiques longitudinales, par sa focale. Une focale typique est de 5mm pour une fonction de focalisation. En se basant sur les équations précédentes, et en considérant une lentille en silice ouverte à f/D=1 (focale/diamètre), de diamètre environ 5mm, la lentille diffractive permettant de réaliser la fonction de focalisation est composée de différentes zones de Fresnel diffractives de hauteur typique de $2\mu$m environ pour une utilisation dans son ordre 1 de diffraction. La zone centrale est un disque de rayon $89\mu$m et la zone la plus externe est un anneau de $1.6\mu$m de largeur. Les différentes zones sont composées de motifs sub-longueur d'onde.

Les motifs de la structure diffractive présentent des largeurs comprises entre 0 et 240 nm et des hauteurs de 2 microns.

L'utilisation d'une optique toute diffractive sub-longueur d'onde seule peut permettre de réaliser la fonction de focalisation, malgré une forte ouverture f/1, dans un système très compact, typiquement 5mm, soit typiquement 16 fois plus compact que le dispositif présenté précédemment de la société Entech.

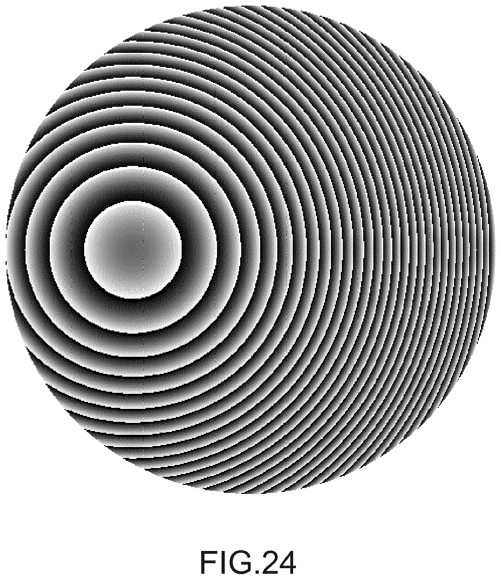

Selon une variante de l'invention, le dispositif de concentration peut comprendre une unique structure diffractive dans laquelle les deux fonctions peuvent être combinées et implémentées sur une seule face du composant dite face de dessous en regard de la cellule photovoltaïque, la face opposée dite de dessus étant plane. La figure 24 illustre ainsi la vue de dessous d'un tel dispositif de concentration. Les niveaux de gris représentent une variation d'indice effectif codée grâce à des motifs sub-longueur d'onde. Les régions plus sombres correspondent à des niveaux d'indice effectif plus élevés. Les zones plus claires correspondent à des niveaux d'indice effectif plus faibles (il est à noter que pour plus de clarté de cette figure et des précédentes, ces figures ne sont pas à l'échelle, ne montrant pas le nombre exact d'anneaux, ce nombre étant en l'occurrence plus élevé).

## Revendications

1. Module photovoltaïque comprenant au moins une cellule photovoltaïque (CV) et au moins un dispositif optique de concentration (Oc), destiné à être illuminé par un flux lumineux émettant à plusieurs longueurs d'onde d'illumination ($\lambda_i$) appartenant à une bande de longueurs d'onde définie par une longueur d'onde minimale ($\lambda_{min}$) et une longueur d'onde maximale ($\lambda_{max}$), ladite bande de longueurs d'onde étant celle du rayonnement solaire de l'ordre de [380nm-1600nm] **caractérisé en ce que** :

   - ledit dispositif optique de concentration est un composant monolithique comprenant :

      • sur une face, une structure diffractive avec des motifs de dimensions sub-longueur définis dans un matériau dit structuré, assurant une fonction de diffraction, lesdits motifs ayant au moins une dimension inférieure ou égale à la longueur d'onde moyenne d'illumination $\lambda_c$ située entre $\lambda_{min}$ et $\lambda_{max}$ divisée par l'indice de réfraction dudit matériau structuré et lesdits motifs étant séparés entre eux par des distances sub-longueur d'onde, définies entre centres de motifs adjacents
      • sur l'autre face une structure de focalisation comprenant une optique réfractive ou une structure diffractive avec des motifs de dimensions sub-longueur définis dans un matériau dit structuré,
      ou

   - ledit dispositif optique de concentration est un composant monolithique comprenant une structure diffractive avec des motifs de dimensions sub-longueur définis dans un matériau dit structuré, assurant sur une même face une fonction de focalisation et une fonction de diffraction, lesdits motifs ayant au moins une dimension inférieure ou égale à la longueur d'onde moyenne d'illumination $\lambda_c$ située entre $\lambda_{min}$ et $\lambda_{max}$ divisée par l'indice de réfraction dudit matériau structuré et lesdits motifs étant séparés entre eux par des distances sub-longueur d'onde, définies entre centres de motifs adjacents

**2.** Module photovoltaïque selon la revendication 1, **caractérisé en ce que** ladite structure diffractive comprend des motifs sub-longueurs d'onde présentant des distances définies entre centres de motifs adjacents, périodiques.

**3.** Module photovoltaïque selon l'une des revendications 1 ou 2, **caractérisé en ce que** le dispositif optique de concentration comporte une structure diffractive comportant des motifs sub-longueur d'onde et une optique réfractive.

**4.** Module photovoltaïque selon l'une des revendications 1 à 3, **caractérisé en ce que** le dispositif optique de concentration comprend deux structures diffractives comportant des motifs sub-longueur d'onde, définis dans au moins un matériau dit structuré, dont l'une assure une fonction de focalisation.

**5.** Module photovoltaïque selon l'une des revendications 1 à 4, **caractérisé en ce que** ladite cellule photovoltaïque comprend au moins un matériau photosensible dans ladite bande de longueurs d'onde.

**6.** Module photovoltaïque selon l'une des revendications 1 à 5, **caractérisé en ce que** ladite cellule photovoltaïque comprend un empilement de matériaux, réalisant une structure multijonction dite verticale, chacun desdits matériaux étant au moins sensibles dans une sous-bande de longueurs d'onde ($\Delta\lambda_1$, $\Delta\lambda_2$, $\Delta\lambda_3$, $\Delta\lambda_4$) appartenant à ladite bande de longueurs d'onde : $\Delta\lambda = [\lambda_{min} ; \lambda_{max}]$.

**7.** Module photovoltaïque selon l'une des revendications 1 à 6, **caractérisé en ce que** ladite cellule photovoltaïque comprend un ensemble de sous-cellules élémentaires adjacentes photovoltaïques dans un même plan comprenant des matériaux sensibles dans des sous-bandes de longueurs d'onde ($\Delta\lambda_1$, $\Delta\lambda_2$, $\Delta\lambda_3$, $\Delta\lambda_4$), appartenant à ladite bande de longueurs d'onde : $\Delta\lambda = [\lambda_{mm} ; \lambda_{max}]$, de manière à constituer une structure multijonction dite horizontale.

**8.** Module photovoltaïque selon la revendication 7, **caractérisé en ce qu'**il comprend des sous-ensembles de cellules élémentaires, photovoltaïques, situés dans des plans différents.

**9.** Module photovoltaïque selon l'une des revendications 7 ou 8, **caractérisé en ce qu'**il comprend des sous-cellules élémentaires photovoltaïques présentant des tailles différentes les unes par rapport aux autres.

**10.** Module photovoltaïque selon l'une des revendications 3 à 9 prise dans sa dépendance à la revendication 3, **caractérisé en ce que** ladite optique réfractive comporte au moins une lentille réfractive de surface courbe.

**11.** Module photovoltaïque selon l'une des revendications 3 à 9 prise dans sa dépendance à la revendication 3, **caractérisé en ce que** ladite optique réfractive comprend au moins une lentille de Fresnel comportant un ensemble de micro-prismes de taille d'environ une à quelques centaines de microns

**12.** Module photovoltaïque selon l'une des revendications 3 à 11 prise dans sa dépendance à la revendication 3, **caractérisé en ce que** l'optique réfractive est réalisée dans le même matériau que le matériau structuré comportant lesdits motifs de dimensions sub-longueur.

**13.** Module photovoltaïque selon l'une des revendications 1 à 12, **caractérisé en ce que** les motifs sont des piliers ou de trous.

**14.** Module photovoltaïque selon l'une des revendications 1 à 13, **caractérisé en ce que** ledit dispositif de concentration comprend une structure diffractive avec des motifs de dimensions sub-longueur définis dans un matériau dit structuré présentant une fonction de correction d'aberration longitudinale et/ou une fonction de séparation spectrale latérale.

**15.** Module photovoltaïque selon la revendication 14, **caractérisé en ce que** ledit dispositif de concentration comprend une zone centrale et des zones externes ;

- chaque zone étant composée de motifs de type piliers à section ronde ou carrée et/ou trous à section ronde ou carrée ;
- les dimensions desdits motifs variant d'une zone à l'autre de façon à coder une variation de l'indice effectif et donc une variation de phase, lesdites variations de dimension pouvant être monotones ou non.

**16.** Module photovoltaïque selon la revendication 15, **caractérisé en ce que** les motifs présentent des dimensions latérales inférieures ou égales à 350nm et l'espacement entre le centre de deux zones consécutives étant d'environ de 350nm, les hauteurs des motifs étant comprises entre 1 micron et une dizaine de microns.

17. Module photovoltaïque selon l'une des revendications 1 à 16, **caractérisé en ce que** ledit matériau structuré est en matériau diélectrique type silice, verre, nitrure de silicium ou de type polymère pouvant être du polydiméthylsiloxane (PDMS), ou du polyméthacrylate de méthyle (PMMA), ou du polycarbonate (PC).

18. Module photovoltaïque selon l'une des revendications 1 à 17, **caractérisé en ce que** les dimensions des motifs sont de l'ordre de 80nm à 250nm en largeur ou en diamètre, de 1 à 2$\mu$m en hauteur.

19. Module photovoltaïque selon l'une des revendications 1 à 18, **caractérisé en ce qu'**il comprend un ensemble de cellules élémentaires photovoltaïques.

20. Module photovoltaïque selon la revendication 19, **caractérisé en ce qu'**il comprend un ensemble de cellules élémentaires photovoltaïques et une structure comportant des motifs sub-longueur d'onde, définis dans un matériau dit structuré, ayant au moins une dimension desdits motifs étant inférieure à ladite longueur d'onde moyenne d'illumination ($\lambda_c$) divisée par l'indice de réfraction dudit matériau structuré, ladite structure assurant une fonction de focalisation et une fonction de diffraction.

21. Module photovoltaïque selon la revendication 19, **caractérisé en ce que** le dispositif optique de concentration comprend un ensemble de micro-lentilles, chaque micro-lentille étant couplée à une structure diffractive comportant des motifs de dimensions sub-longueur.

22. Module photovoltaïque selon la revendication 19, **caractérisé en ce que** le dispositif optique de concentration comprend un ensemble de lentilles de Fresnel à micro-prismes, chaque lentille de Fresnel étant couplée à une structure diffractive comportant des motifs de dimensions sub-longueur.

23. Panneau solaire pour générateur solaire pour satellite comprenant au moins un module photovoltaïque selon l'une des revendications précédentes.

**Patentansprüche**

1. Fotovoltaikmodul, das wenigstens eine Fotovoltaikzelle (CV) und wenigstens eine optische Konzentrationsvorrichtung (Oc) umfasst, die zum Beleuchten durch einen Lichtstrom bestimmt ist, der mit mehreren Beleuchtungswellenlängen ($\lambda_i$) emittiert, die zu einem Wellenlängenband gehören, das von einer Mindestwellenlänge ($\lambda_{min}$) und einer Höchstwellenlänge ($\lambda_{max}$) definiert wird, wobei das Wellenlängenband das der Sonnenstrahlung in der Größenordnung von [380 nm - 1600 nm] ist, **dadurch gekennzeichnet, dass**:

   - die optische Konzentrationsvorrichtung eine monolithische Komponente ist, die Folgendes umfasst:

      • auf einer Fläche eine diffraktive Struktur mit Motiven von Sublängenabmessungen, definiert in einem strukturierten Material, das eine Diffraktionsfunktion gewährleistet, wobei die Motive wenigstens eine Abmessung gleich oder kleiner als die mittlere Beleuchtungswellenlänge $\lambda_c$ hat, die zwischen $\lambda_{min}$ und $\lambda_{max}$ liegt, unterteilt durch den Refraktionsindex des strukturierten Materials, und wobei die Motive voneinander durch Wellensublängendistanzen getrennt sind, definiert zwischen Mittelpunkten von benachbarten Motiven;
      • auf der anderen Fläche eine Fokussierstruktur, die eine refraktive Optik oder eine diffraktive Struktur mit Motiven von Sublängenabmessungen umfasst, definiert in einem strukturierten Material, oder

   - die optische Konzentrationsvorrichtung eine monolithische Komponente ist, die eine diffraktive Struktur mit Motiven von Sublängenabmessungen umfasst, definiert in einem strukturierten Material, das auf einer selben Fläche eine Fokussierfunktion und eine Diffraktionsfunktion gewährleistet, wobei die Motive wenigstens eine Abmessung gleich oder kleiner als die mittlere Beleuchtungswellenlänge $\lambda_c$ hat, die zwischen $\lambda_{min}$ und $\lambda_{max}$ liegt, unterteilt durch den Refraktionsindex des strukturierten Materials, und wobei die Motive voneinander durch Wellensublängendistanzen getrennt sind, definiert zwischen Mittelpunkten von benachbarten Motiven.

2. Fotovoltaikmodul nach Anspruch 1, **dadurch gekennzeichnet, dass** die diffraktive Struktur Wellensublängenmotive umfasst, die Distanzen aufweisen, die zwischen Mittelpunkten von benachbarten periodischen Motiven definiert sind.

3. Fotovoltaikmodul nach Anspruch 1 oder 2, **dadurch gekennzeichnet, dass** die optische Konzentrationsvorrichtung eine diffraktive Struktur umfasst, die Wellensublängenmotive und eine refraktive Optik umfasst.

4. Fotovoltaikmodul nach einem der Ansprüche 1 bis 3, **dadurch gekennzeichnet, dass** die optische Konzentrationsvorrichtung zwei diffraktive Strukturen umfasst, die Wellensublängenmotive umfassen, definiert in wenigstens einem strukturierten Material, von denen eines eine Fokussierfunktion gewährleistet.

5. Fotovoltaikmodul nach einem der Ansprüche 1 bis 4, **dadurch gekennzeichnet, dass** die Fotovoltaikzelle wenigstens ein fotosensibles Material in dem Wellenlängenband umfasst.

6. Fotovoltaikmodul nach einem der Ansprüche 1 bis 5, **dadurch gekennzeichnet, dass** die Fotovoltaikzelle einen Materialstapel umfasst, der eine vertikale Mehrübergangsstruktur bildet, wobei jedes der Materialien wenigstens in einem Wellenlängensubband ($\Delta\lambda_1$, $\Delta\lambda_2$, $\Delta\lambda_3$, $\Delta\lambda_4$) empfindlich ist, das zu dem Wellenlängenband $\Delta\lambda = [\lambda_{min}; \lambda_{max}]$ gehört.

7. Fotovoltaikmodul nach einem der Ansprüche 1 bis 6, **dadurch gekennzeichnet, dass** die Fotovoltaikzelle eine Baugruppe von elementaren benachbarten Fotovoltaiksubzellen in einer selben Ebene umfasst, die in den Wellenlängensubbändern ($\Delta\lambda_1$, $\Delta\lambda_2$, $\Delta\lambda_3$, $\Delta\lambda_4$) sensible Materialien umfasst, die zu demselben Wellenlängenband $\Delta\lambda = [\lambda_{min}; \lambda_{max}]$ gehören, um eine horizontale Mehrübergangsstruktur zu bilden.

8. Fotovoltaikmodul nach Anspruch 7, **dadurch gekennzeichnet, dass** es Teilsätze von elementaren Fotovoltaikzellen umfasst, die in unterschiedlichen Ebenen liegen.

9. Fotovoltaikmodul nach Anspruch 7 oder 8, **dadurch gekennzeichnet, dass** es elementare Fotovoltaiksubzellen umfasst, die zueinander unterschiedliche Größen aufweisen.

10. Fotovoltaikmodul nach einem der Ansprüche 3 bis 9 in Abhängigkeit von Anspruch 3, **dadurch gekennzeichnet, dass** die refraktive Optik wenigstens eine refraktive Linse mit gekrümmter Oberfläche umfasst.

11. Fotovoltaikmodul nach einem der Ansprüche 3 bis 9 in Abhängigkeit von Anspruch 3, **dadurch gekennzeichnet, dass** die refraktive Optik wenigstens eine Fresnel-Linse umfasst, die einen Satz von Mikroprismen mit einer Größe zwischen einem und einigen Hundert Mikron umfasst.

12. Fotovoltaikmodul nach einem der Ansprüche 3 bis 11 in Abhängigkeit von Anspruch 3, **dadurch gekennzeichnet, dass** die refraktive Optik aus demselben Material gebildet ist wie das strukturierte Material, das die Motive von Sublängenabmessungen umfasst.

13. Fotovoltaikmodul nach einem der Ansprüche 1 bis 12, **dadurch gekennzeichnet, dass** die Motive Säulen oder Löcher sind.

14. Fotovoltaikmodul nach einem der Ansprüche 1 bis 13, **dadurch gekennzeichnet, dass** die Konzentrationsvorrichtung eine diffraktive Struktur mit Motiven von Sublängenabmessungen umfasst, definiert in einem strukturierten Material, das eine longitudinale Aberrationskorrekturfunktion und/oder eine laterale spektrale Trennfunktion hat.

15. Fotovoltaikmodul nach Anspruch 14, **dadurch gekennzeichnet, dass** die Konzentrationsvorrichtung eine zentrale Zone und externe Zonen umfasst:

- wobei jede Zone aus Motiven des Säulentyps mit rundem oder quadratischem Querschnitt und/oder des Löchertyps mit rundem oder quadratischem Querschnitt besteht;
- wobei die Abmessungen der Motive von einer Zone zur anderen variieren, um eine Variation des effektiven Indexes und somit eine Phasenvariation zu codieren, wobei die Abmessungsvariationen monoton sein können oder nicht.

16. Fotovoltaikmodul nach Anspruch 15, **dadurch gekennzeichnet, dass** die Motive laterale Abmessungen gleich oder kleiner als 350 nm aufweisen und der Abstand zwischen dem Mittelpunkt von beiden konsekutiven Zonen etwa 350 nm beträgt, wobei die Höhen der Motive zwischen 1 Mikron und an die zehn Mikron betragen.

**17.** Fotovoltaikmodul nach einem der Ansprüche 1 bis 16, **dadurch gekennzeichnet, dass** das strukturierte Material ein dielektrisches Material des Typs Kieselerde, Glas, Siliciumnitrid oder des Polymertyps ist, der Polydimethylsiloxan (PDMS) oder Methylpolymethacrylat (PMMA) oder Polycarbonat (PC) sein kann.

**18.** Fotovoltaikmodul nach einem der Ansprüche 1 bis 17, **dadurch gekennzeichnet, dass** die Abmessungen der Motive in der Größenordnung von 80 nm bis 250 nm Breite oder Durchmesser und 1 bis 2 $\mu$m Höhe sind.

**19.** Fotovoltaikmodul nach einem der Ansprüche 1 bis 18, **dadurch gekennzeichnet, dass** es einen Satz von elementaren Fotovoltaikzellen umfasst.

**20.** Fotovoltaikmodul nach Anspruch 19, **dadurch gekennzeichnet, dass** es einen Satz von elementaren Fotovoltaikzellen und eine Struktur umfasst, die Wellensublängenmotive umfasst, definiert in einem strukturierten Material, wobei wenigstens eine Abmessung der Motive kleiner ist als die mittlere Beleuchtungswellenlänge ($\lambda_c$), unterteilt durch den Refraktionsindex des strukturierten Materials, wobei die Struktur eine Fokussierfunktion und eine Diffraktionsfunktion gewährleistet.

**21.** Fotovoltaikmodul nach Anspruch 19, **dadurch gekennzeichnet, dass** die optische Konzentrationsvorrichtung einen Satz von Mikrolinsen umfasst, wobei jede Mikrolinse mit einer diffraktiven Struktur gekoppelt ist, die Motive von Sublängenabmessungen umfasst.

**22.** Fotovoltaikmodul nach Anspruch 19, **dadurch gekennzeichnet, dass** die optische Konzentrationsvorrichtung einen Satz von Fresnel-Linsen mit Mikroprismen umfasst, wobei jede Fresnel-Linse mit einer diffraktiven Struktur gekoppelt ist, die Motive von Sublängenabmessungen umfasst.

**23.** Solarplatte für einen Solargenerator für einen Satellit, umfassend wenigstens ein Fotovoltaikmodul nach einem der vorherigen Ansprüche.

**Claims**

**1.** Photovoltaic module comprising at least one photovoltaic cell (CV) and at least one concentration optic device (Oc), intended to be illuminated by a light flux emitting at a plurality of illumination wavelengths ($\lambda_i$) belonging to a band of wavelengths defined by a minimum wavelength ($\lambda_{min}$) and a maximum wavelength ($\lambda_{max}$), said band of wavelengths being that of the solar radiation of the order of [380 nm-1600 nm], **characterised in that**:

- said concentration optic device is a monolithic component comprising:

• on one surface, a diffractive structure comprising subwavelength patterns, defined in a so-called structured material, ensuring a diffraction function, said patterns having at least one dimension less than or equal to the average illumination wavelength $\lambda_c$ situated between $\lambda_{min}$ and $\lambda_{max}$ divided by the refractive index of said structured material and said patterns being separated from one another by subwavelength distances, defined between centres of adjacent patterns
• on the other surface, a focusing structure comprising a refractive optic or a diffractive structure with subwavelength patterns, defined in a so-called structured material,
or

- said concentration optic device is a monolithic component comprising a diffractive structure with subwavelength patterns defined in a so-called structured material ensuring on a same surface a focusing function and a diffraction function, said patterns having at least one dimension less than or equal to the average illumination wavelength $\lambda_c$ situated between $\lambda_{min}$ and $\lambda_{max}$ divided by the refractive index of said structured material and said patterns being separated from one another by subwavelength distances, defined between centres of adjacent patterns.

**2.** Photovoltaic module according to Claim 1, **characterised in that** said diffractive structure comprises subwavelength patterns exhibiting distances defined between centres of adjacent patterns that are periodic.

**3.** Photovoltaic module according to one of Claims 1 or 2, **characterised in that** the concentration optic device comprises a diffractive structure comprising subwavelength patterns and a refractive optic.

4. Photovoltaic module according to one of Claims 1 to 3, **characterised in that** the concentration optic device comprises two diffractive structures comprising subwavelength patterns, defined in at least one so-called structured material, of which one ensures a focusing function.

5. Photovoltaic module according to one of Claims 1 to 4, **characterised in that** said photovoltaic cell comprises at least one photosensitive material in said band of wavelengths.

6. Photovoltaic module according to one of Claims 1 to 5, in which said photovoltaic cell comprises a stack of materials, producing a so-called vertical multijunction structure, each of said materials being at least sensitive in a subband of wavelengths ($\Delta\lambda_1$, $\Delta\lambda_2$, $\Delta\lambda_3$, $\Delta\lambda_4$) belonging to said band of wavelengths: $\Delta\lambda = [\lambda_{min}; \lambda_{max}]$.

7. Photovoltaic module according to one of Claims 1 to 6, **characterised in that** said photovoltaic cell comprises a set of elementary adjacent photovoltaic subcells in one and the same plane comprising materials sensitive in subbands of wavelengths ($\Delta\lambda_1$, $\Delta\lambda_2$, $\Delta\lambda_3$, $\Delta\lambda_4$), belonging to said band of wavelengths: $\Delta\lambda = [\lambda_{min}; \lambda_{max}]$, so as to constitute a so-called horizontal multijunction structure.

8. Photovoltaic module according to Claim 7, **characterised in that** it comprises subsets of elementary photovoltaic cells, situated in different planes.

9. Photovoltaic module according to one of Claims 7 or 8, **characterised in that** it comprises elementary photovoltaic subcells exhibiting different sizes relative to one another.

10. Photovoltaic module according to one of Claims 3 to 9, when dependent on Claim 3, **characterised in that** said refractive optic comprises at least one curved surface refractive lens.

11. Photovoltaic module according to one of Claims 3 to 9, when dependent on Claim 3, **characterised in that** said refractive optic comprises at least one Fresnel lens comprising a set of microprisms of an approximate size of one to a few hundreds of microns.

12. Photovoltaic module according to one of Claims 3 to 11, when dependent on Claim 3, **characterised in that** the refractive optic is produced in the same material as the structured material comprising said patterns of sublength dimensions.

13. Photovoltaic module according to one of Claims 1 to 12, **characterised in that** the patterns are pillars or holes.

14. Photovoltaic module according to one of Claims 1 to 13, **characterised in that** said concentration device comprises a diffractive structure with patterns of sublength dimensions defined in a so-called structured material having a longitudinal aberration correction function and/or a lateral spectral separation function.

15. Photovoltaic module according to Claim 14, **characterised in that** said concentration device comprises a central zone and outer zones;

   - each zone being made up of patterns of pillar type with round or square section and/or hole type with round or square section;
   - the dimensions of said patterns varying from one zone to the other so as to code a variation of the effective index and therefore a phase variation, said variations of dimension being able to be monotonic or not.

16. Photovoltaic module according to Claim 15, **characterised in that** the patterns exhibit lateral dimensions less than or equal to 350 nm and the spacing between the centre of two consecutive zones being approximately 350 nm, the heights of the patterns being between 1 micron and 10 or so microns.

17. Photovoltaic module according to one of Claims 1 to 16, **characterised in that** said structured material is a dielectric material of silica, glass, silicon nitride type or of polymer type that can be polydimethylsiloxane (PDMS), or poly(methyl methacrylate) (PMMA), or polycarbonate (PC).

18. Photovoltaic module according to one of Claims 1 to 17, **characterised in that** the dimensions of the patterns are of the order of 80 nm to 250 nm in width or in diameter, 1 to 2 $\mu$m in height.

**19.** Photovoltaic module according to one of Claims 1 to 18, **characterised in that** it comprises a set of elementary photovoltaic cells.

**20.** Photovoltaic module according to Claim 19, **characterised in that** it comprises a set of elementary photovoltaic cells and a structure comprising subwavelength patterns, defined in a so-called structured material, having at least one dimension of said patterns that is less than said average illumination wavelength ($\lambda_c$) divided by the refractive index of said structured material, said structure ensuring a focusing function and a diffraction function.

**21.** Photovoltaic module according to Claim 19, **characterised in that** the concentration optic device comprises a set of microlenses, each microlens being coupled to a diffractive structure comprising patterns of sublength dimensions.

**22.** Photovoltaic module according to Claim 19, **characterised in that** the concentration optic device comprises a set of Fresnel lenses with microprisms, each Fresnel lens being coupled to a diffractive structure comprising patterns of sublength dimensions.

**23.** Solar panel for solar generator for satellite comprising at least one photovoltaic module according to one of the preceding Claims.

Lentille de Fresnel

x500

Cellule CV

FIG.1

$\Delta\lambda_2$

$\Delta\lambda_3$

$\Delta\lambda_4$

$\Delta\lambda_1$

4  5  6  7  8 9 1    2    3    4

Energie (eV)

$M_1$

$M_2$

$M_3$

$M_4$

CV

FIG.2a

FIG.2b

FIG.3

FIG.4

FIG.5a

FIG.5b

FIG.6

FIG.7a  FIG.7b  FIG.7c

FIG.8a

FIG.8b

FIG.8c

FIG.9a

500

FIG.9b

OR$_o$

Smi$_\lambda$

CPV

CV$_o$

FIG.10

Sm1$_\lambda$   L$_1$   Sm2$_\lambda$   L$_2$   Sm3$_\lambda$   L$_3$   Sm4$_\lambda$   L$_4$

M$_1$

M$_1$   M$_3$   M$_2$   M$_3$   CV$_i$   M$_2$

## FIG.11

Sm1$_\lambda$   L$_1$   Sm2$_\lambda$   L$_2$   Sm3$_\lambda$   L$_3$   Sm4$_\lambda$   L$_4$

CV$_{i_1}$   CV$_i$   CV$_{i_2}$   CV$_{i_3}$

## FIG.12

λ

Zone
d'ombrage

n    h= λ / (n-1)

Λ

Pertes

Diffraction

FIG.13a

Lumière non polarisée

Calcul
électromagnétique

Efficacité (%)

Expérience
(1998)

θ

Grandes périodes                    Petites périodes

FIG.13b

FIG.14

FIG.15

Densité de puissance spectrale du spectre standard AM1.5

FIG.16

FIG.17

FIG.18

FIG.19

FIG.20a

FIG.20b

$Z_C$

$Z_N$

FIG.21a

$Z_C$

$Z_N$

FIG.21b

FIG.22

FIG.23a

FIG.23b

FIG.23c

FIG.24

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6075200 A
- US 20140130855 A
- US 20120312351 A
- US 20070103782 A

**Littérature non-brevet citée dans la description**

- **P. BENÍTEZ ; J.C. MIÑANO ; P. ZAMORA ; R. MOHEDANO ; A. CVETKOVIC ; M. BULJAN ; J. CHAVES ; M. HERNÁNDEZ.** High performance Fresnel-based photovoltaic Concentrator. *Optics express,* 2010, vol. 18 (S1), A25-A40
- **A. DAVIS ; F. KUHNLENZ.** Optical Design using Fresnel Lenses. *Optik & Photonik,* Décembre 2007
- Ultra-light streched Fresnel lens solar concentrator for space power applications. *SPIE 48th Annual meeting,* 2003
- **C. MICHEL et al.** Study of solar concentrator for space, based on a diffractive/refractive combinaison. *Renewable Energy and the Environment, OSA, SM2A2,* 2012
- **PH. LALANNE ; S. ASTILEAN ; P. CHAVEL ; E. CAMBARND ; H.LAUNOIS.** Blazed·binary sub-wavelength gratings with efficiencies larger than those of conventional échelette gratings. *Opt. Lett.,* 1998, vol. 23, 1081-1083

- **MS.L LEE ; PH LALANNE ; J C. RODIER ; P CHAVEL. E CAMBRIL ; Y CHEN.** Imaging with blazed·binary diffractive elements. *Opt. A : Pure Appl. Opt.,* 2002, vol. 4, 119
- **C. SAUVAN ; PH.LALANNE ; M-S. L. LEE.** Broadband blazing with artificial dielectrics. *Opt. Lett.,* 2004, vol. 29, 1593-1595
- **C. RIBOT.** *PhD Thesis from University of Paris Sud,* 2008
- **M-S. L. LEE ; S. BANSROPUN ; O. HUET ; S. CASSETTE ; B. LOISEAUX ; A. P. WOOD ; C. SAUVAN ; P. LALANNE.** Sub-wavelength structures for broadband diffractive optics. *ICO 2005, 0602-34,* 2005
- **G. BLOOM ; CH. LARAT ; E. LALLIER ; M-SL. LEE-BOUHOURS ; B. LOISEAUX ; J-P. HUIGNARD.** Design and optimization of a high efficiency array generator in the mid-IR with binary subwavelength grooves. *Appl. Opt.,* 2011, vol. 50, 701-709
- **GUILLAUME BLOOM.** Combinaison cohérente de lasers à cascade quantique. Université PARIS XI ORSAY, 14 Février 2012